# EUROPEAN PATENT APPLICATION

(11) **EP 2 698 827 A1**
(43) Date of publication of application: **19.02.2014**
(21) Application number: 11863421.1
(22) Date of filing: 28.04.2011
(51) Int. Cl.: H01L 31/04, H01B 1/20, H01B 1/22, H01L 21/28, H01L 21/288

(54) **ELECTRODE PASTE COMPOSITION, SOLAR-CELL ELEMENT, AND SOLAR CELL**

(30) Priority: 14.04.2011 JP 2011090520
(71) Applicant: Hitachi Chemical Company, Ltd., Chiyoda-ku Tokyo 100-6606 (JP)
(72) Inventor: ADACHI, Shuichirou, Tsukuba-shi, Ibaraki 300-4247 (JP); YOSHIDA, Masato, Tsukuba-shi, Ibaraki 300-4247 (JP); NOJIRI, Takeshi, Tsukuba-shi, Ibaraki 300-4247 (JP); IWAMURO, Mitsunori, Tsukuba-shi, Ibaraki 300-4247 (JP); KIZAWA, Keiko, Tsukuba-shi, Ibaraki 300-4247 (JP); AOYAGI, Takuya, Hitachi-shi, Ibaraki 319-1292 (JP); YAMAMOTO, Hiroki, Hitachi-shi, Ibaraki 319-1292 (JP); NAITO, Takashi, Hitachi-shi, Ibaraki 319-1292 (JP); KATO, Takahiko, Hitachi-shi, Ibaraki 319-1292 (JP)
(74) Representative: HOFFMANN EITLE
(86) International application number: PCT/JP2011/060471
(87) International publication number: WO 2012/140786

(57) **Abstract**

The present invention provides a paste composition for an electrode, the paste composition including a phosphorus-containing copper alloy particle, a tin-containing particle, a glass particle, a solvent and a resin. The present invention also provides a photovoltaic cell element having an electrode formed from the paste composition, and a photovoltaic cell.

## Description

### Technical Field

The present invention relates to a paste composition for an electrode, a photovoltaic cell element and a photovoltaic cell.

### Background Art

Generally, electrodes are formed on a light-receiving surface and a back surface of a silicon photovoltaic cell. In order to efficiently extract electrical energy that has been converted in a photovoltaic cell from incident light, it is necessary that the electrodes have sufficiently low volume resistivity and form a favorable ohmic contact with a Si substrate. In particular, in the case of an electrode formed on a light-receiving surface, the width of wires tends to be reduced, and the aspect ratio of the electrode tends to be increased in order to suppress the loss in the amount of incidence of sunlight to a minimum.

An electrode for a light-receiving surface of a photovoltaic cell is typically produced as follows. That is, the light-receiving surface electrode is formed by forming a texture (asperity) on a light-receiving surface of a p-type silicon substrate, and thermally diffusing phosphorus or the like at high temperature to form an n-type silicon layer; applying a conductive composition onto the n-type silicon layer by screen printing or the like; and sintering the same in the atmosphere at 800°C to 900°C. The conductive composition for forming a light-receiving surface electrode contains a conductive metal powder, glass particles and various additives.

As the conductive metal powder, a silver powder is typically used. The reasons therefor include that silver particles have a low volume resistivity of 1.6×10⁻⁶ Ω·cm; that silver particles can be sintered via self-reduction under the aforementioned sintering conditions; that silver particles can form a favorable ohmic contact with a silicon substrate; and that a solder material exhibits excellent wettability with respect to electrodes made from silver particles, whereby tab wires, that electrically connect photovoltaic cell elements with each other, are favorably attached during module formation in which photovoltaic cell elements are sealed with a glass substrate or the like.

As described above, a conductive composition containing silver particles exhibits favorable properties as an electrode for photovoltaic cells. Meanwhile, since silver is a noble metal and is expensive itself, and also in view of resource issues, proposals of a paste material to replace a silver-containing conductive composition have been desired. Copper, which is utilized as a semiconductor wiring material, is one of the materials viewed as an alternative for silver. Copper is in abundant supply and is low in price, i.e., approximately a hundredth of that of silver. However, since copper is a material that easily oxidizes at a high temperature of 200°C or higher in the atmosphere, it is difficult to form an electrode according to the processes described above.

In order to eliminate such a drawback of copper, for example, Japanese Patent Application Laid-Open (JP-A) Nos. 2005-314755 and 2004-217952 disclose copper particles that do not oxidize during high-temperature sintering, the copper particles being imparted with oxidation resistance through various techniques.

### SUMMARY OF THE INVENTION

### Technical Problem

However, copper particles such as those described above exhibit oxidation resistance at a temperature of up to 300°C, and are mostly oxidized at high temperatures of from 800°C to 900°C. Therefore, the copper particles still have not been practically utilized in electrodes for photovoltaic cells. Further, there is a problem in that additives or the like, which are added to impart oxidation resistance to copper particles, disturb sintering of the copper particles during sintering and, as a result, electrodes with low resistance, such as those made of silver, cannot be obtained.

As another technique of suppressing oxidization of copper, there is a special process of sintering a conductive composition, in which copper is used as a conductive metal powder, in an atmosphere of nitrogen or the like.

However, this technique requires an environment that is sealed completely with an atmospheric gas such as that described above, in order to thoroughly suppress oxidization of copper particles, which is not suitable for mass production of photovoltaic cell elements from a viewpoint of production costs.

Another problem to overcome in applying copper for electrodes for photovoltaic cells is ohmic contact properties of copper with respect to a silicon substrate. Namely, even if an electrode of copper can be formed without oxidation during high-temperature sintering, interdiffusion of copper and silicon may be caused as a result of direct contact of copper with a silicon substrate, and a reactant phase (Cu₃Si) of copper and silicon may be formed at an interface of the electrode and the silicon substrate.

Formation of Cu₃Si may occur within a region of several µm from the interface of the silicon substrate, which may cause cracking on the Si substrate side. Further, Cu₃Si may penetrate through an n-type silicon layer that is formed previously on the silicon substrate, thereby deteriorating semiconductor performances (pn-junction properties) of the photovoltaic cell. In addition, the formed Cu₃Si may lift up an electrode made of copper and inhibit adhesiveness of the electrode with respect to the silicon substrate, thereby reducing the mechanical strength of the electrode.

The present invention is made in view of the problems described above and aims to provide a paste composition for an electrode, which can suppress oxidization of copper during sintering, form an electrode with low resistivity, and form a copper-containing electrode in which formation of a reactant phase of copper and a silicon substrate is suppressed and that has a favorable ohmic contact. The present invention also aims to provide a photovoltaic cell element and a photovoltaic cell having an electrode formed with the paste composition for an electrode.

### Solution to Problem

The inventors of the present invention have made intensive studies to approach the aforementioned problems and, as a result, completed the present invention. Specifically, the present invention encompasses the following aspects.

A first aspect of the present invention is a paste composition for an electrode, the paste composition including phosphorus-containing copper alloy particles, tin-containing particles, glass particles, a solvent and a resin.

The paste composition for an electrode preferably has a phosphorus content in the phosphorus-containing copper alloy particles of from 6 mass% to 8 mass%.

The tin-containing particles preferably include at least one selected from the group consisting of tin alloy particles in which a content of tin is 1 mass% or more and tin particles.

The glass particles preferably have a glass softening point of 650°C or less and a crystallization initiation temperature of more than 650°C.

In the paste composition for an electrode, the content of the tin-containing particles is preferably from 5 mass% to 70 mass%, with respect to the total content of the phosphorus-containing copper alloy particles and the tin-containing particles, which is defined as 100 mass%.

The paste composition for an electrode preferably further contains silver particles, and more preferably, the content of the silver particles is from 0.1 mass% to 10 mass% with respect to the total content of the phosphorus-containing copper alloy particles, the tin-containing particles and the silver particles, which is defined as 100 mass%.

In the paste composition for an electrode, the total content of the phosphorus-containing copper alloy particles, the tin-containing particles and the silver particles is preferably from 70 mass% to 94 mass%, the content of the glass particles is preferably from 0.1 mass% to 10 mass%, and the total content of the solvent and the resin is preferably from 3 mass% to 29.9 mass%.

A second aspect of the present invention is a photovoltaic cell element including an electrode formed on a silicon substrate, the electrode being formed by sintering the paste composition for an electrode which has been applied to the silicon substrate.

The electrode preferably contains a Cu-Sn alloy phase and a Sn-P-O glass phase, and more preferably, the Sn-P-O glass phase is positioned between the Cu-Sn alloy phase and the silicon substrate.

A third aspect of the present invention is a photovoltaic cell including the photovoltaic cell element, and a tab wire that is positioned on the electrode of the photovoltaic cell element.

### Effects of the Invention

According to the present invention, it is possible to provide a paste composition for an electrode, which is capable of suppressing oxidization of copper during sintering, forming an electrode with low resistivity, and forming a copper-containing electrode in which formation of a reactant phase between copper and the silicon substrate is suppressed and that has a favorable ohmic contact. It is also possible to provide a photovoltaic cell element, and a photovoltaic cell having an electrode formed from the paste composition for an electrode.

### BRIEF DESCRIPTION OF THE DRAWINGS

Fig. 1 is a schematic cross-sectional view showing an example of a silicon photovoltaic cell element according to the present invention;
Fig. 2 is a schematic plan view showing an example of a light-receiving surface of a silicon photovoltaic cell element according to the present invention;
Fig. 3 is a schematic plan view showing an example of a back surface of a silicon photovoltaic cell element according to the present invention;
Fig. 4 is a schematic plan view showing an example of a structure of a back surface-side electrode of a back-contact type photovoltaic cell element according to the present invention;
Fig. 5 is a schematic perspective view showing an example of the AA cross-section configuration of a back-contact type photovoltaic cell element according to the present invention shown in Fig. 4;
Fig. 6 is a schematic perspective view showing an example of the AA cross-section configuration of a back-contact type photovoltaic cell element according to the present invention shown in Fig. 4; and
Fig. 7 is a schematic perspective view showing an example of the AA cross-section configuration of a back-contact type photovoltaic cell element according to the present invention shown in Fig. 4.

### BEST MODE FOR CARRYING OUT THE INVENTION

In the present specification, the term "process" refers not only to an independent process but also to a process that cannot be clearly distinguished from another process, insofar as an intended result of the process is attained. Further, a numerical range expressed by "A to B" refers to a range including A and B as the minimum value and the maximum value, respectively.

With regard to the amounts of components of a composition, when plural substances corresponding to the same component exist in the composition, the amount of the component refers to the total amount of the plural substances, unless otherwise specified.

### <Paste composition for electrode>

The paste composition for an electrode according to the present invention contains at least one kind of phosphorus-containing copper alloy particles, at least one kind of tin-containing particles, at least one kind of glass particles, at least one kind of a solvent, and at least one kind of a resin. By using a paste composition having a constitution as described above, it is possible to suppress the oxidation of copper during sintering in the atmosphere and form an electrode with low resistivity. Further, it is possible to suppress the formation of a reactant phase of copper and a silicon substrate and obtain a favorable ohmic contact between the thus-formed electrode and the silicon substrate.

### (Phosphorus-containing copper alloy particles)

The paste composition for an electrode contains at least one kind of phosphorus-containing copper alloy particles. As a phosphorus-containing copper alloy, a brazing material referred to as a copper-phosphorus brazing alloy (phosphorus concentration: approximately 7 mass% or less) is known. Although a copper-phosphorus brazing alloy is used also as a jointing material of copper and copper, an electrode that exhibits excellent oxidation resistance and a low volume resistivity can be formed, by means of a reducing property of phosphorus with respect to oxidized copper by using phosphorus-containing copper alloy particles in the paste composition for an electrode according to the present invention. Furthermore, effects of enabling sintering an electrode at low temperature, thereby reducing processing costs, can be achieved.

From the viewpoints of oxidation resistance and low resistivity, the content of phosphorus in the phosphorus-containing copper alloy according to the present invention is preferably from 6 mass% to 8 mass%, more preferably from 6.3 mass% to 7.8 mass%, and further preferably from 6.5 mass% to 7.5 mass%. When the phosphorus content in a phosphorus-containing copper alloy is 8 mass% or less, even lower resistivity can be attained, and efficiency in production of phosphorus-containing copper alloy particles can be favorable. When the phosphorus content is 6 mass% or more, even more excellent oxidation resistance can be attained.

The phosphorus-containing copper alloy particles are an alloy containing copper and phosphorus, but may further contain other atoms. Examples of other atoms include Ag, Mn, Sb, Si, K, Na, Li, Ba, Sr, Ca, Mg, Be, Zn, Pb, Cd, Tl, V, Sn, Al, Zr, W, Mo, Ti, Co, Ni and Au.

The content of other atoms in the phosphorus-containing copper alloy particles may be, for example, 3 mass% or less in the phosphorus-containing copper alloy particles, and is preferably 1 mass% or less from the viewpoints of oxidation resistance and low resistivity.

In the present invention, the phosphorus-containing copper alloy particles may be used singly or in a combination of two or more kinds thereof.

Although the particle size of the phosphorus-containing copper alloy particles is not particularly restricted, the particle size at an accumulated weight of 50% (hereinafter, also abbreviated as "D50%") is preferably from 0.4 µm to 10 µm, and more preferably from 1 µm to 7 µm. When the particle size is 0.4 µm or more, oxidation resistance can be improved more efficiently. When the particle size is 10 µm or less, the contact area between phosphorus-containing copper alloy particles, or the contact area between phosphorus-containing copper alloy particles and tin-containing particles as described later, in an electrode, can be increased, whereby resistivity can be lowered more efficiently. The particle size of phosphorus-containing copper alloy particles may be measured using a particle size distribution analyzer (MICROTRAC MT3300, trade name, manufactured by Nikkiso Co., Ltd.).

The shape of the phosphorus-containing copper alloy particles is not particularly restricted, and it may be any of quasispherical, flat, block-like, plate-like, scaly, and the like. From the viewpoints of oxidation resistance and low resistivity, the phosphorus-containing copper alloy particles preferably have a quasispherical, flat or plate-like shape.

The content of the phosphorus-containing copper alloy particles in the paste composition for an electrode is not particularly restricted. From the viewpoint of low resistivity, the content in the paste composition for an electrode is preferably from 20 mass% to 85 mass%, more preferably from 25 mass% to 80 mass%, and further preferably from 30 mass% to 75 mass%.

Phosphorus-containing copper alloys may be produced by an ordinary method. Phosphorus-containing copper alloy particles may be produced from a phosphorus-containing copper alloy, in which the amount of phosphorus has been adjusted, by an ordinary method of preparing a metal powder, such as a water atomization method. Details of the water atomization method may be referred to descriptions in Kinzoku Binran (Metals Handbook, published by Maruzen Co., Ltd.), etc.

More specifically, desired phosphorus-containing copper alloy particles may be produced by melting a phosphorus-containing copper alloy and making the same into a powder by spraying from nozzles, followed by drying and classifying the obtained powder. Further, phosphorus-containing alloy particles having a desired particle diameter may be obtained by appropriately selecting the conditions for classification.

### (Tin-containing particles)

The paste composition for an electrode according to the present invention contains at least one kind of tin-containing particles. By containing tin-containing particles, in addition to the phosphorus-containing copper alloy particles, an electrode with low resistivity can be formed in a sintering process described below.

It is considered, for example, that phosphorus-containing copper alloy particles and tin-containing particles react with each other in a sintering process, whereby an electrode composed of a Cu-Sn alloy phase and a Sn-P-O glass phase is formed. It is believed that the Cu-Sn alloy phase form a compact bulk in the electrode, which functions as a conductive layer, whereby an electrode with low resistivity is formed.

The compact bulk herein refers to a structure in which Cu-Sn alloy phases in massive form closely contact each other in a three-dimensional continuous manner.

Further, in the event an electrode is formed with the paste composition for an electrode according to the present invention on a substrate containing silicon (hereinafter also referred to "silicon substrate"), an electrode that exhibits high adhesion with respect to the silicon substrate can be formed, and a favorable ohmic contact between the electrode and the silicon substrate can be achieved.

It is considered, for example, as follows. The phosphorus-containing copper alloy particles and tin-containing particles react with each other in a sintering process, whereby an electrode composed of a Cu-Sn alloy phase and a Sn-P-O glass phase is formed. Since the Cu-Sn alloy phase is a compact bulk, the Sn-P-O glass phase is formed between the Cu-Sn alloy phase and the silicon substrate. As a result, it is believed that adhesion of the Cu-Sn alloy phase with respect to the silicon substrate is improved. Further, since the Sn-P-O glass phase functions as a barrier layer that inhibits interdiffusion of copper and silicon, it is believed that a favorable ohmic contact between an electrode formed by sintering and a silicon substrate can be achieved. More specifically, it is considered that a favorable ohmic contact can be obtained while suppressing formation of a reaction phase (Cu₃Si), which is formed when an electrode containing copper is contacted directly with silicon and heated, and maintaining adhesion with respect to the silicon substrate without deteriorating the semiconductor performances (e.g. pn-junction properties).

Such effects are generally expressed in cases in which an electrode is formed on a substrate containing silicon with a paste composition for an electrode according to the present invention, and there is no particular restriction on the type of the substrate containing silicon. Examples of the substrate containing silicon include silicon substrates for photovoltaic cells and silicon substrates for other semiconductor devices than photovoltaic cells.

Specifically, according to the present invention, in which phosphorus-containing copper alloy particles and tin-containing particles are combined in the paste composition for an electrode, an electrode that exhibits a low volume resistivity and excellent oxidation resistance can be formed by utilizing the reducing property of phosphorous atoms with respect to oxidized copper in the phosphorus-containing copper alloy particles. Next, through reaction between the phosphorus-containing copper alloy particles and the tin-containing particles, an Sn-P-O glass phase and a conductive layer composed of a Cu-Sn alloy phase are formed while maintaining the low volume resistivity. It is thus considered, for example, that the two characteristic mechanisms can be attained during sintering by the Sn-P-O glass phase that functions as a barrier layer that prevents interdiffusion of copper and silicon, i.e., suppressed formation of a reactant phase between the electrode and the silicon substrate, and formation of a favorable ohmic contact with a copper electrode.

The tin-containing particles are not particularly restricted, insofar as they are particles containing tin. Among the tin-containing particles, at least one kind selected from tin particles or tin alloy particles is preferred, and at least one kind selected from tin particles or tin alloy particles in which the tin content is 1 mass% or more is more preferred.

The purity of tin in the tin particles is not particularly restricted. For example, the purity of tin particles may be 95 mass% or more, preferably 97 mass% or more, and more preferably 99 mass% or more.

The type of the tin alloy particles is not particularly restricted, insofar as they are alloy particles containing tin. Among the tin alloy particles, from the viewpoints of the melting point and reactivity with phosphorus-containing copper alloy particles, tin alloy particles in which the tin content is 1 mass% or more are preferable, tin alloy particles in which the tin content is 3 mass% or more are more preferable, tin alloy particles in which the tin content is 5 mass% or more are further preferable, and tin alloy particles in which the tin content is 10 mass% or more are especially preferable.

Examples of the tin alloy particles include particles of an Sn-Ag alloy, an Sn-Cu alloy, an Sn-Ag-Cu alloy, an Sn-Ag-Sb alloy, an Sn-Ag-Sb-Zn alloy, an Sn-Ag-Cu-Zn alloy, an Sn-Ag-Cu-Sb alloy, an Sn-Ag-Bi alloy, an Sn-Bi alloy, an Sn-Ag-Cu-Bi alloy, an Sn-Ag-In-Bi alloy, an Sn-Sb alloy, an Sn-Bi-Cu alloy, an Sn-Bi-Cu-Zn alloy, an Sn-Bi-Zn alloy, an Sn-Bi-Sb-Zn alloy, an Sn-Zn alloy, an Sn-In alloy, an Sn-Zn-In alloy, and an Sn-Pb alloy.

Among the tin alloy particles, tin alloy particles of Sn-3.5Ag, Sn-0.7Cu, Sn-3.2Ag-0.5Cu, Sn-4Ag-0.5Cu, Sn-2.5Ag-0.8Cu-0.5Sb, Sn-2Ag-7.5Bi, Sn-3Ag-5Bi, Sn-58Bi, Sn-3.5Ag-3In-0.5Bi, Sn-3Bi-8Zn, Sn-9Zn, Sn-52In, Sn-40Pb, or the like have a melting point that is equal to or lower than that of Sn (232°C). Consequently, these tin alloy particles are suitable because they melt at an early stage of sintering and cover the surfaces of phosphorus-containing copper alloy particles, thereby enabling uniform reaction with the phosphorus-containing copper alloy particles. The above expression of tin alloy particles refers to, in a case of Sn-AX-BY-CZ, that tin alloy particles contain A mass% of element X, B mass% of element Y, and C mass% of element Z.

In the present invention, tin-containing particles may be used singly or used in a combination of two or more kinds thereof.

The tin-containing particles may further contain other atoms that may be unavoidably incorporated therein. Examples of the other atoms that are unavoidably incorporated include Ag, Mn, Sb, Si, K, Na, Li, Ba, Sr, Ca, Mg, Be, Zn, Pb, Cd, Tl, V, Al, Zr, W, Mo, Ti, Co, Ni, and Au.

The content of other atoms in the tin-containing particles may be, for example, 3 mass% or less in the tin-containing particles, and from the viewpoints of the melting point and reactivity with phosphorus-containing copper alloy particles, the content of other atoms is preferably 1 mass% or less.

Although the particle size of the tin-containing particles is not particularly restricted, the particle size at an accumulated weight of 50% (hereinafter, also abbreviated as "D50%") is preferably from 0.5 µm to 20 µm, more preferably from 1 µm to 15 µm, and further preferably from 5 µm to 15 µm. When the particle size is 0.5 µm or more, oxidation resistance of tin-containing particles by themselves is improved. When the particle size is 20 µm or less, the contact area with phosphorus-containing copper alloy particles, which exist in the electrode, is increased, thereby allowing a reaction with the phosphorus-containing copper alloy particles to progress effectively.

The shape of the tin-containing particles is not particularly restricted, and may be any of quasispherical, flat, block-like, plate-like, scaly, and the like. From the viewpoints of oxidation resistance and low resistivity, the tin-containing particles preferably have a quasispherical, flat, or plate-like shape.

The content of the tin-containing particles in the paste composition for an electrode according to the present invention is not particularly limited. Among others, when the total content of the phosphorus-containing copper alloy particles and the tin-containing particles is defined as 100 mass%, the content of the tin-containing particles is preferably from 5 mass% to 70 mass%, more preferably from 7 mass% to 65 mass%, and further preferably from 9 mass% to 60 mass%.

When the content of the tin-containing particles is 5 mass% or more, a more uniform reaction with the phosphorus-containing copper alloy particles can be achieved. When the content of the tin-containing particles is 70 mass% or less, a sufficient volume of Cu-Sn alloy phase can be formed, and the volume resistivity of an electrode can be further lowered.

### (Glass particles)

The paste composition for an electrode according to the present invention contains at least one kind of glass particles. When the paste composition for an electrode contains glass particles, adhesion between an electrode portion and a substrate is improved during sintering. Further, especially in the formation of an electrode at a light-receiving surface side of a photovoltaic cell, a silicon nitride film, which is an antireflection coating, is removed by so called fire-through during sintering, and an ohmic contact between an electrode and a silicon substrate is obtained.

From the viewpoints of adhesion with respect to a substrate and reduction in resistivity of the electrode, the glass particles preferably contain glass having a glass softening point of 650°C or less and a crystallization initiation temperature of higher than 650°C. The glass softening point is measured by an ordinary method using a thermal mechanical analyzer (TMA), and the crystallization initiation temperature is measured by an ordinary method using a thermogravimetric-differential thermal analyzer (TG-DTA).

In the event that the paste composition for an electrode according to the present invention is used for an electrode formed at the light-receiving surface side of a photovoltaic cell, glass particles that are used commonly in the art may be used without particular restriction, as long as they are capable of removing an antireflection coating by softening or melting at an electrode forming temperature, oxidizing the silicon nitride film to which the glass particles contact, and taking in the oxidized silicon dioxide.

Typically, glass particles to be contained in a paste composition for an electrode are composed of glass containing lead, since the material is capable of efficiently taking in silicon dioxide. Examples of glass containing lead include those described in Japanese Patent No. 3050064, which may be suitably used in the present invention.

Considering environmental impact, lead-free glass, which does not substantially contain lead, is preferably used in the present invention. Examples of the lead-free glass include the lead-free glass described in paragraphs No. [0024] to [0025] of Japanese Patent Application Laid-Open (JP-A) No. 2006-313744, and the lead-free glass described in Japanese Patent Application Laid-Open (JP-A) No. 2009-188281, and any one of such lead-free glass may be selected appropriately and used in the present invention.

When the paste composition for an electrode according to the present invention is used for an electrode other than that formed at a light-receiving surface side of a photovoltaic cell, for example, for a back-surface output electrode, or a through-hole electrode or a back-surface electrode for a back-contact type photovoltaic cell element, inclusion of a material that is necessary for fire through, such as lead, may be omitted by using glass particles containing glass having a glass softening point of 650°C or less and a crystallization initiation temperature of higher than 650°C.

Examples of the glass component of the glass particles to be used in the paste composition for an electrode according to the present invention include silicon dioxide (SiO₂), phosphorus oxide (P₂O₅), aluminum oxide (Al₂O₃), boron oxide (B₂O₃), vanadium oxide (V₂O₅), potassium oxide (K₂O), bismuth oxide (Bi₂O₃), sodium oxide (Na₂O), lithium oxide (Li₂O), barium oxide (BaO), strontium oxide (SrO), calcium oxide (CaO), magnesium oxide (MgO), beryllium oxide (BeO), zinc oxide (ZnO), lead oxide (PbO), cadmium oxide (CdO), tin oxide (SnO), zirconium oxide (ZrO₂), tungsten oxide (WO₃), molybdenum oxide (MoO₃), lanthanum oxide (La₂O₃), niobium oxide (Nb₂O₅), tantalum oxide (Ta₂O₅), yttrium oxide (Y₂O₃), titanium oxide (TiO₂), germanium oxide (GeO₂), tellurium oxide (TeO₂), lutetium oxide (Lu₂O₃), antimony oxide (Sb₂O₃), copper oxide (CuO), iron oxide (FeO), silver oxide (AgO) and manganese oxide (MnO).

Among these, at least one kind selected from the group consisting of SiO₂, P₂O₅, Al₂O₃, B₂O₃, V₂O₅, Bi₂O₃, ZnO and PbO is preferably used as the glass component. Furthermore, at least one kind selected from the group consisting of SiO₂, PbO, B₂O₃, Bi₂O₃ and Al₂O₃ is more preferably used as the glass component. When such glass particles are used, the softening point is effectively lowered. Further, since wettability with respect to phosphorus-containing copper alloy particles, or silver particles that are optionally included, can be improved, sintering among the particles in the sintering process is promoted and an electrode with even lower resistivity can be formed.

Meanwhile, from the viewpoint of low contact resistivity, glass particles containing phosphorus pentoxide (phosphate glass, P₂O₅ glass particles) are preferable, and glass particles containing vanadium pentoxide and phosphorus pentoxide (P₂O₅-V₂O₅ glass particles) are more preferable. By containing vanadium pentoxide, oxidation resistance is further improved and resistivity of an electrode is further lowered. This is considered to be because of reduction in the softening point of the glass as a result of further containing, for example, vanadium pentoxide. When glass particles containing phosphorus pentoxide and vanadium pentoxide (P₂O₅-V₂O₅ glass particles) are used, the content of vanadium pentoxide is preferably 1 mass% or more, and more preferably from 1 mass% to 70 mass%, with respect to the total mass of the glass.

Although the particle size of the glass particles used in the present invention is not particularly restricted, the particle size at an accumulated weight of 50% (D50%) is preferably from 0.5 µm to 10 µm, and more preferably from 0.8 µm to 8 µm or less. When the particle size is 0.5 µm or more, workability in producing the paste composition for an electrode is improved. When the particle size is 10 µm or less, the particles can be dispersed homogeneously in the paste composition for an electrode. As a result, fire-through can be efficiently caused in a sintering process, and adhesion with respect to a silicon substrate can be improved.

The shape of the glass particles is not particularly restricted, and may be any of quasispherical, flat, block-like, plate-like, scaly, and the like. From the viewpoints of oxidation resistance and low resistivity, the glass particles preferably have a quasispherical, flat, or plate-like shape.

The content of the glass particles in the total mass of the paste composition for an electrode is preferably from 0.1 mass% to 10 mass%, more preferably from 0.5 mass% to 8 mass%, and further preferably from 1 mass% to 8 mass%. When the content of the glass particles is within the above ranges, oxidation resistance, reduction in resistivity of an electrode, and reduction in contact resistance can be attained more effectively, and the reaction between the phosphorus-containing copper alloy particles and the tin-containing particles can be promoted.

### (Solvent and resin)

The paste composition for an electrode according to the present invention contains at least one kind of solvent and at least one kind of resin. By including a solvent and a resin, liquid properties (such as viscosity or surface tension) of the paste composition for an electrode according to the present invention can be adjusted to suitable liquid properties according to a method of applying the paste composition to a silicon substrate or the like.

The solvent is not particularly restricted, and examples thereof include: a hydrocarbon solvent such as hexane, cyclohexane, or toluene; a chlorinated hydrocarbon solvent such as dichloroethylene, dichloroethane, or dichlorobenzene; a cyclic ether solvent such as tetrahydrofuran, furan, tetrahydropyran, pyran, dioxane, 1,3-dioxolane, or trioxane; an amide solvent such as N,N-dimethylformamide or N,N-dimethylacetamide; a sulfoxide solvent such as dimethylsulfoxide or diethylsulfoxide; a ketone solvent such as acetone, methyl ethyl ketone, diethylketone, or cyclohexanone; an alcohol compound such as ethanol, 2-propanol, 1-butanol, or diacetone alcohol; a polyhydric alcohol ester solvent such as 2,2,4-trimethyl-1,3-pentanediol monoacetate, 2,2,4-trimethyl-1,3-pentanediol monopropiolate, 2,2,4-trimethyl-1,3-pentanediol monobutyrate, 2,2,4-trimethyl-1,3-pentanediol monoisobutyrate, 2,2,4-triethyl-1,3-pentanediol monoacetate, ethylene glycol monobutyl ether acetate, or diethylene glycol monobutyl ether acetate; a polyhydric alcohol ether solvent such as butyl cellosolve, diethylene glycol monobutyl ether, and diethylene glycol diethyl ether; a terpene solvent, such as α-terpinene, α-terpineol, myrcene, allo-ocimene, limonene, dipentene, α-pinene, β-pinene, terpineol, carvone, ocimene, or phellandrene; and mixtures of these solvents.

From the viewpoint of coating properties of the paste composition for an electrode according to the present invention when it is applied to a silicon substrate and from the viewpoint of printing properties thereof, the solvent is preferably at least one selected from a polyhydric alcohol ester solvent, a terpene solvent, and a polyhydric alcohol ether solvent, and at least one selected from a polyhydric alcohol ester solvent and a terpene solvent is more preferable.

According to the present invention, the solvents may be used singly or in a combination of two or more kinds thereof.

A resin used commonly in the art may be used without particular restriction, insofar as it is capable of being thermally decomposed during sintering. Specific examples of the resin include: a cellulosic resin such as methylcellulose, ethylcellulose, carboxymethylcellulose, or nitrocellulose; polyvinyl alcohols; polyvinylpyrrolidones; an acrylic resin; a vinyl acetate/acrylic ester copolymer; a butyral resin such as polyvinyl butyral; an alkyd resin such as a phenol modified alkyd resin or a castor oil fatty acid modified alkyd resin; an epoxy resin; a phenol resin; and a rosin ester resin.

From the viewpoint of a property of disappearance during sintering, at least one selected from a cellulosic resin or an acrylic resin is preferable as the resin used in the present invention.

In the present invention, the resin may be used singly or in a combination of two or more kinds thereof.

The weight-average molecular weight of the resin according to the present invention is not particularly restricted. The weight-average molecular weight is preferably from 5,000 to 500,000, and more preferably from 10,000 to 300,000. When the weight-average molecular weight of the resin is 5,000 or more, increase in viscosity of the paste composition for an electrode can be suppressed. The increase in viscosity is considered to be, for example, caused by aggregation of particles due to insufficient steric repulsion when the resin is adsorbed to phosphorus-containing copper alloy particles and tin-containing particles. When the weight-average molecular weight of the resin is 500,000 or less, aggregation of the resin in a solvent is suppressed, and increase in viscosity of the paste composition for an electrode can be suppressed.

In addition, when the weight-average molecular weight of the resin is 500,000 or less, increase in a combustion temperature of the resin may be suppressed. As a result, when the paste composition for an electrode is subjected to sintering, remaining of the resin as a foreign material due to incomplete combustion can be suppressed, and an electrode having even lower resistivity can be obtained.

The contents of the solvent and the resin in the paste composition for an electrode according to the present invention may be selected appropriately, depending on the desired liquid properties and the types of the solvent and resin to be used. For example, the total content of the solvent and the resin in the total mass of the paste composition for an electrode is preferably from 3 mass% to 29.9 mass%, more preferably from 5 mass% to 25 mass%, and further preferably from 7 mass% to 20 mass%.

When the total content of the solvent and the resin is within the above ranges, application suitability of the paste composition for an electrode to a silicon substrate may become favorable, and an electrode having desired width and height can be formed more easily.

Further, in the paste composition for an electrode according to the present invention, from the viewpoints of oxidation resistance and low resistivity of an electrode, it is preferred that the total content of the phosphorus-containing copper alloy particles and the tin-containing particles is from 70 mass% to 94 mass%, the content of the glass particles is from 0.1 mass% to 10 mass%, and the total content of the solvent and the resin is from 3 mass% to 29.9 mass%; it is more preferred that the total content of the phosphorus-containing copper alloy particles and the tin-containing particles is from 74 mass% to 88 mass%, the content of the glass particles is from 0.5 mass% to 8 mass%, and the total content of the solvent and the resin is from 7 mass% to 20 mass%; and it is further preferred that the total content of the phosphorus-containing copper alloy particles and the tin-containing particles is from 74 mass% to 88 mass%, the content of the glass particles is from 1 mass% to 8 mass%, and the total content of the solvent and the resin is from 7 mass% to 20 mass%.

### (Silver particles)

The paste composition for an electrode according to the present invention preferably further includes silver particles. By including silver particles, oxidation resistance is further improved and resistivity of an electrode is further lowered. In addition, separation of Ag particles in an Sn-P-O glass phase, which is formed by a reaction between the phosphorus-containing copper alloy particles and the tin-containing particles, further improves the ohmic contact between a Cu-Sn alloy phase in an electrode layer and a silicon substrate. Moreover, when a photovoltaic cell module is formed, an effect of improving the solder jointing property can be obtained.

The silver that constitutes the silver particles may further contain other atoms that may be unavoidably incorporated therein. Examples of the other atoms that may be unavoidably incorporated include Sb, Si, K, Na, Li, Ba, Sr, Ca, Mg, Be, Zn, Pb, Cd, Tl, V, Sn, Al, Zr, W, Mo, Ti, Co, Ni, and Au.

The content of the other atoms in the silver particles may be, for example, 3 mass% or less of the silver particles, and from the viewpoints of the melting point and reduction in resistivity of an electrode, the content of the other atoms is preferably 1 mass% or less.

Although the particle size of the silver particles used in the present invention is not particularly restricted, the particle size at an accumulated weight of 50% (D50%) is preferably from 0.4 µm to 10 µm, and more preferably from 1 µm to 7 µm. When the particle size is 0.4 µm or more, oxidation resistance is improved more effectively. When the particle size is 10 µm or less, the contact area between the silver particles and the phosphorus-containing copper alloy particles and the tin-containing particles, in an electrode, is increased, and the resistivity is lowered more effectively.

The shape of the silver particles is not particularly restricted, and may be any of quasispherical, flat, block-like, plate-like, scaly, and the like. From the viewpoints of oxidation resistance and low resistivity, the silver particles preferably have a quasispherical, flat, or plate-like shape.

Further, in the event that the paste composition for an electrode according to the present invention contains silver particles, the content of the silver particles is preferably from 0.1 mass% to 10 mass%, and more preferably from 0.5 mass% to 8 mass%, when the total content of the phosphorus-containing copper alloy particles, the tin-containing particles, and the silver particles, is defined as 100 mass%.

In the paste composition for an electrode according to the present invention, from the viewpoints of oxidation resistance, reduction in resistivity of an electrode, and application suitability to a silicon substrate, the total content of the phosphorus-containing copper alloy particles, the tin-containing particles and the silver particles in the paste composition for an electrode is preferably from 70 mass% to 94 mass%, and more preferably from 74 mass% to 88 mass%. When the total content of the phosphorus-containing copper alloy particles, the tin-containing particles and the silver particles is 70 mass% or more, a favorable viscosity for application of the paste composition for an electrode can be obtained easily. When the total content of the phosphorus-containing copper alloy particles, the tin-containing particles and the silver particles is 94 mass% or less, unevenness during application of the paste composition for an electrode can be more effectively suppressed.

When the paste composition for an electrode according to the present invention further contains silver particles, from the viewpoints of oxidation resistance and low resistivity of an electrode, it is preferred that the total content of the phosphorus-containing copper alloy particles, the tin-containing particles and the silver particles is from 70 mass% to 94 mass%, the content of the glass particles is from 0.1 mass% to 10 mass%, and the total content of the solvent and the resin is from 3 mass% to 29.9 mass%; it is more preferred that the total content of the phosphorus-containing copper alloy particles, the tin-containing particles and the silver particles is from 74 mass% to 88 mass%, the content of the glass particles is from 0.5 mass% to 8 mass%, and the total content of the solvent and the resin is from 7 mass% to 20 mass%; and it is further preferred that the total content of the phosphorus-containing copper alloy particles, the tin-containing particles and the silver particles is from 74 mass% to 88 mass%, the content of the glass particles is from 1 mass% to 8 mass%, and the total content of the solvent and the resin is from 7 mass% to 20 mass%.

### (Flux)

The paste composition for an electrode may further include at least one kind of flux. By including a flux, an oxidized film, which is formed on the surfaces of phosphorus-containing copper alloy particles, can be removed and a reducing reaction of phosphorus-containing copper alloy particles during sintering can be promoted. Further, melting of the tin-containing particles during sintering is also promoted, whereby the reaction with the phosphorus-containing copper alloy particles is promoted. As a result, oxidation resistance is further improved and resistivity of an electrode to be formed is further lowered. Moreover, an effect of enhancing the adhesion between an electrode material and a silicon substrate is obtained.

The flux used in the present invention is not particularly restricted, insofar as it is capable of removing an oxidized film formed on the surfaces of phosphorus-containing copper alloy particles, and promoting the melting of the tin-containing particles. Preferred examples of the flux include a fatty acid, a boric acid compound, a fluoride compound, and a fluoroborate compound.

More specifically, examples of the flux include lauric acid, myristic acid, palmitic acid, stearic acid, sorbic acid, stearolic acid, propionic acid, boron oxide, potassium borate, sodium borate, lithium borate, potassium fluoroborate, sodium fluoroborate, lithium fluoroborate, potassium bifluoride, sodium bifluoride, lithium bifluoride, potassium fluoride, sodium fluoride, and lithium fluoride.

Among them, from the viewpoints of heat resistance during a process of sintering an electrode material (i.e., a property of flux not volatilizing at a low temperature stage of sintering) and supplementary oxidation resistance for phosphorus-containing copper alloy particles, examples of the especially preferred flux include potassium borate and potassium fluoroborate.

According to the present invention, the flux may be used singly or in a combination of two or more kinds thereof.

In the event that the paste composition for an electrode according to the present invention contains a flux, from the viewpoints of allowing the phosphorus-containing copper alloy particles to effectively exhibit oxidation resistance and promoting the melting of the tin-containing particles, and also from the viewpoint of lowering the porosity at a portion in which the flux has been removed after the completion of sintering an electrode material, the content of the flux in the total mass of the paste composition for an electrode is preferably from 0.1 mass% to 5 mass%, more preferably from 0.3 mass% to 4 mass%, further preferably from 0.5 mass% to 3.5 mass%, yet further preferably from 0.7 to 3 mass%, and particularly preferably from 1 mass% to 2.5 mass%.

### (Other components)

The paste composition for an electrode according to the present invention may include other components that are commonly used in the art, as necessary, in addition to the components as described above. Examples of the other components include a plasticizer, a dispersant, a surfactant, an inorganic binder, a metal oxide, a ceramic, and an organometallic compound.

The method for producing the paste composition for an electrode according to the present invention is not particularly restricted. For example, the paste composition for an electrode according to the present invention may be produced by dispersing/mixing phosphorus-containing copper alloy particles, tin-containing particles, glass particles, solvent and resin, and optionally silver particles or the like, by an ordinary dispersing/mixing method. The dispersing/mixing method is not particularly restricted, and may be selected from ordinary dispersing/mixing methods.

### <Method for producing electrode using paste composition for electrode>

In a method for producing an electrode with the paste composition for an electrode according to the present invention, the paste composition for an electrode is applied to a region in which an electrode is to be formed, and then dried, followed by sintering, whereby an electrode is formed in a desired region. By using the paste composition for an electrode, an electrode with low resistivity can be formed even if a sintering treatment is carried out in the presence of oxygen (e.g. in the atmosphere).

Specifically, for example, in the event that an electrode for a photovoltaic cell is formed using the paste composition for an electrode, the paste composition for an electrode may be applied to a silicon substrate in a desired shape, dried and sintered, whereby an electrode for a photovoltaic cell with low resistivity is formed in a desired shape. By using the paste composition for an electrode, an electrode with low resistivity can be formed even if a sintering treatment is carried out in the presence of oxygen (e.g. in the atmosphere). Further, when an electrode is formed on a silicon substrate, the electrode exhibits excellent adhesion with respect to the silicon substrate and a favorable ohmic contact can be attained.

Examples of the application method of the paste composition for an electrode include a screen printing method, an inkjet method and a dispenser method. From the viewpoint of productivity, a screen printing method is preferable.

In a case in which the paste composition for an electrode according to the present invention is applied by screen printing, the paste composition for an electrode preferably has a viscosity in a range of from 20 Pa·s to 1,000 Pa·s. The viscosity of the paste composition for an electrode is measured using a Brookfield HBT viscometer at 25°C.

The application amount of the paste composition for an electrode may be selected appropriately, according to the size of the electrode to be formed. The application amount of the paste composition for an electrode may be, for example, from 2 g/m² and 10 g/m², and preferably from 4 g/m² and 8 g/m².

With regard to the conditions for heat treatment (sintering) for forming an electrode using the paste composition for an electrode according to the present invention, heat treatment conditions that are commonly used in the art may be employed.

Although the heat treatment temperature (sintering temperature) is typically from 800°C to 900°C, heat treatment conditions at lower temperatures may be applied in the event where the paste composition for an electrode according to the present invention is used. For example, an electrode that exhibits favorable properties can be formed at a heat treatment temperature of from 450°C to 850°C.

Further, the heat treatment time may be selected appropriately according to the heat treatment temperature or the like, and may be, for example, from 1 second to 20 seconds.

A heat treatment apparatus may be appropriately selected from those which are capable of heating up to a temperature within the ranges as described above, and examples thereof include an infrared heating oven and a tunnel oven. An infrared heating oven, in which electrical energy is input directly to a material to be heated in the form of electromagnetic waves and is converted to thermal energy, is high in efficiency and capable for performing rapid heating in a short period of time. Further, since no combustion product is generated and heating is carried out in a non-contact manner, contamination of an electrode to be formed can be prevented. A tunnel oven, in which sintering is carried out during conveying a sample in an automatic and continuous manner from an inlet to an outlet, is capable of carrying out heating uniformly because of the division of the oven body and because it is possible to control the conveying speed. From the viewpoint of photovoltaic performances of a photovoltaic cell element, a tunnel oven is suitable for carrying out the heat treatment.

### <Photovoltaic cell element and method for producing the same>

A photovoltaic cell element according to the present invention includes an electrode formed by sintering the paste composition for an electrode that has been applied onto a silicon substrate. As a result, a photovoltaic cell element that exhibits favorable characteristics can be obtained, and superior productivity of the photovoltaic cell element can be achieved.

In the present specification, the term "photovoltaic cell element" refers to an element including a silicon substrate having a pn-junction formed thereon, and an electrode formed on the silicon substrate. The term "photovoltaic cell" refers to an assembly that includes an electrode for a photovoltaic cell element having a tab wire provided thereon, which may be plural photovoltaic cell elements that are connected to each other via tab wires, and is sealed using a sealing resin or the like.

In the following, specific examples of the photovoltaic cell element according to the present invention will be described with reference to the drawings. However, the present invention is not limited thereto.

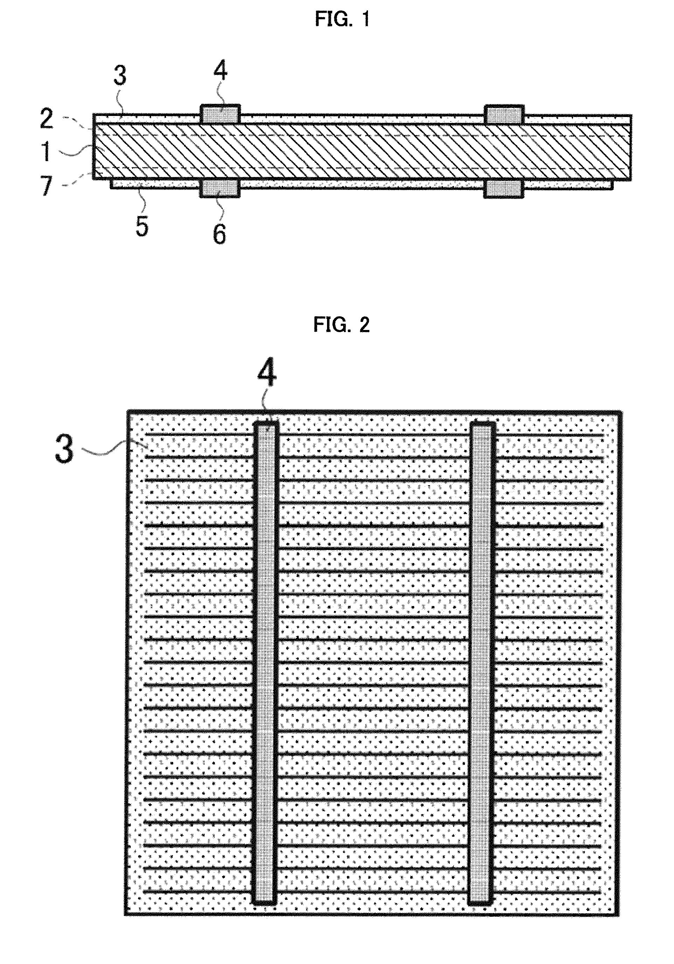

Fig. 1, Fig. 2 and Fig. 3 show schematic views of a cross section, a light-receiving surface and a back surface of an example of a typical photovoltaic cell element, respectively.

As outlined in Fig. 1, monocrystalline or polycrystalline silicon, or the like is typically used for a semiconductor substrate 1 of a photovoltaic cell element. The semiconductor substrate 1 contains boron and the like, and constitutes a p-type semiconductor. In order to suppress reflection, the light-receiving surface side thereof is roughened to form asperity (also referred to as "texture", not illustrated) with an etching solution composed of NaOH and IPA (isopropyl alcohol). The light-receiving surface side is doped with phosphorus or the like to form an n⁺ diffusion layer 2 with a thickness of a sub-micron scale, and a pn-junction region is formed at a boundary thereof with a p-type bulk portion. Further, on the light-receiving surface side, an antireflection coating 3 made of silicon nitride or the like is provided on the n⁺ diffusion layer 2, to a film thickness of approximately 90 nm, by PECVD or the like.

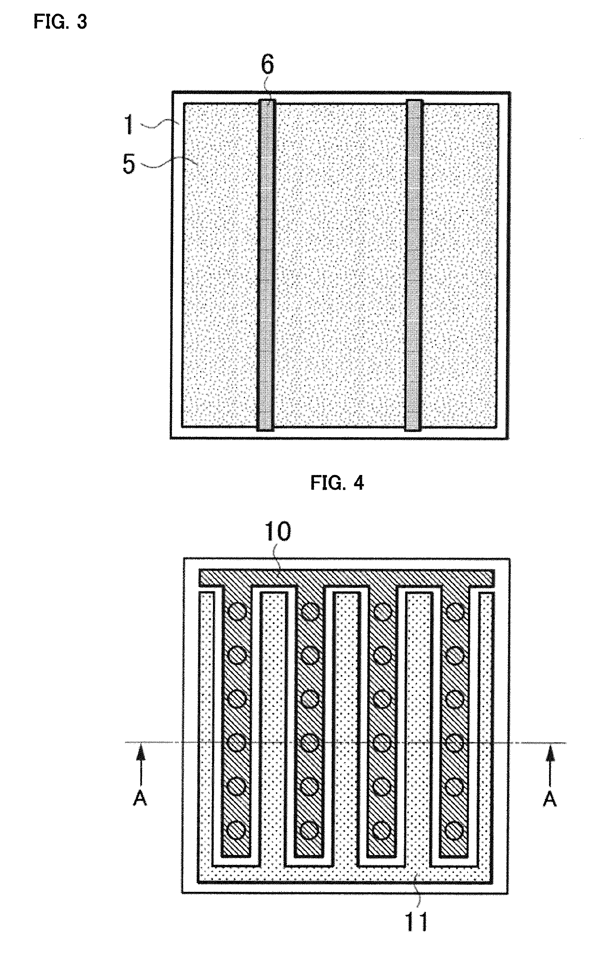

Next, a method for forming a light-receiving surface electrode 4 provided on the light-receiving surface side as outlined in Fig. 2, and a method for forming a collecting electrode 5 and a method for forming a power output electrode 6, which are formed on the back surface as outlined in Fig. 3, will be described.

A light-receiving surface electrode 4 and a back-surface power output electrode 6 are formed using the paste composition for an electrode according to the present invention. The back-surface collecting electrode 5 is formed using an aluminum electrode paste composition containing a glass powder. A first method for forming a light-receiving surface electrode 4, a back-surface collecting electrode 5, and a back-surface power output electrode 6, includes applying the paste compositions by screen printing or the like to form desired patterns, respectively, drying the same, and sintering the same simultaneously in the atmosphere at approximately 450°C to 850°C. According to the present invention, by using the paste composition for an electrode, an electrode that exhibits superior resistivity and superior contact resistivity can be formed even if sintering is carried out at a relatively low temperature.

At that time, at the light-receiving surface side, glass particles contained in the paste composition for an electrode, which forms a light-receiving surface electrode 4, and an antireflection layer 3 are allowed to react (also referred to as fire-through). As a result, the light-receiving surface electrode 4 and an n⁺ diffusion layer 2 are electrically connected (ohmic contact).

According to the present invention, since a light-receiving surface electrode 4 is formed using the paste composition for an electrode, oxidation of copper is suppressed even though copper is included as a conductive metal. Therefore, a light-receiving surface electrode 4 with low resistivity can be formed at a high yield.

In the present invention, the electrode is preferably formed by including a Cu-Sn alloy phase and an Sn-P-O glass phase, and more preferably, the Sn-P-O glass phase is positioned between the Cu-Sn alloy phase and the silicon substrate (not illustrated). In this way, a reaction between copper and the silicon substrate is suppressed, and an electrode that exhibits low resistance and superior adhesion can be formed.

On the back surface side, aluminum, which is contained in the aluminum electrode paste composition that forms a back-surface collecting electrode 5, diffuses into the back surface of a p-type silicon substrate 1 during sintering, thereby forming a p⁺ diffusion layer 7. In this way, an ohmic contact is obtained between the p-type silicon substrate 1 and the back-surface collecting electrode 5, and the back-surface power output electrode 6.

A second method for forming a light-receiving surface electrode 4, a back-surface collecting electrode 5, and a back-surface power output electrode 6, includes performing printing using an aluminum electrode paste composition that forms a back-surface collecting electrode 5, drying the same, and then sintering the same in the atmosphere at approximately 750°C to 850°C, thereby forming a back-surface collecting electrode 5; and subsequently performing printing using the paste composition for an electrode according to the present invention on each of the light-receiving surface side and the back surface side, drying the same, and then sintering the same in the atmosphere at approximately 450°C to 650°C, thereby forming a light-receiving surface electrode 4 and a back surface power output electrode 6.

This method is effective from the viewpoints as set forth below. Specifically, when sintering of an aluminum electrode paste is performed to form a back-surface collecting electrode 5 at a sintering temperature of 650°C or less, there may be cases in which formation of a p⁺ diffusion layer is insufficient owing to the insufficient sintering of aluminum particles and the insufficient diffusion of aluminum into the p-type silicon substrate 1, depending on the composition of the aluminum paste. In such cases, formation of an ohmic contact between the p-type silicon substrate 1 on the back surface and the back-surface collecting electrode 5, or the back-surface power output electrode 6, may be insufficient. As a result, photovoltaic performances of a photovoltaic cell element may be lowered. Therefore, it is preferable to form the back-surface collecting electrode 5 at a sintering temperature that is suitable for an aluminum electrode paste composition (e.g. 750°C to 850°C), and subsequently form the light-receiving surface electrode 4 and the back-surface power output electrode 6 by performing printing using the paste composition for an electrode according to the present invention, drying the same, and then sintering the same at a relatively low temperature (450°C to 650°C).

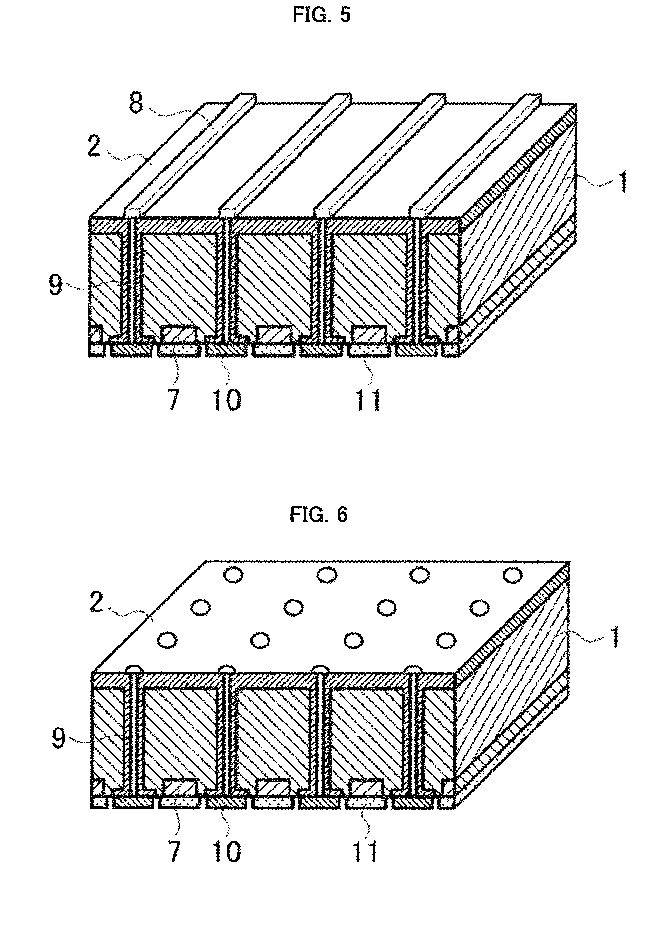

Fig. 4 shows a schematic plan view of the back-surface side electrode structure that is common to so-called back-contact type photovoltaic cell elements, which are another embodiment of the present invention. Fig. 5, Fig. 6 and Fig.7 show perspective views of outlined structures of photovoltaic cell elements, respectively, which are different embodiments of back-contact type photovoltaic cell elements. Fig. 5, Fig. 6 and Fig. 7 show perspective views of the cross-section taken at the AA line shown in Fig. 4.

In a photovoltaic cell element having a structure shown in the perspective view of Fig. 5, through-holes, which penetrate from the light-receiving surface side to the back surface side, are formed in the p-type silicon substrate 1 by laser drilling, etching, or the like. Further, a texture (not illustrated) that enhances the light incidence efficiency is formed on the light-receiving surface side. In addition, an n⁺ diffusion layer 2 is formed on the light-receiving surface side by performing an n-type diffusion treatment, and an antireflection coating is formed on the n⁺ diffusion layer 2. They may be formed by the same process as that used for conventional crystalline Si-type photovoltaic cell elements.

Next, the through-holes formed in the above process are filled with the paste composition for an electrode according to the present invention by a printing method, an inkjet method, or the like. Further, printing is performed on the light-receiving surface side using the paste composition for an electrode according to the present invention into a grid form. In this way, a composition layer which constitutes through-hole electrodes 9 and light-receiving surface collecting electrodes 8, is thus formed.

It is preferred to use a paste having an optimal composition for each process of filling and printing, such as viscosity. However, the filling and the printing may be carried out at once with a paste having the same composition.

On the back surface side, an n⁺ diffusion layer 2 and a p⁺ diffusion layer 7, which prevent recombination of carriers, are formed. Examples of the impurity elements included in the p⁺ diffusion layer 7 include boron (B) and aluminum (Al). The p⁺ diffusion layer 7 may be formed by, for example, performing a thermal diffusion treatment using boron as a diffusion source during a production process of a photovoltaic cell element, prior to forming the antireflection coating. Alternatively, in a case in which aluminum is used, the p⁺ diffusion layer 7 may be formed by performing printing using an aluminum paste and sintering the same on the opposite surface side during the printing process.

On the back surface side, as shown in a plan view of Fig. 4, back surface electrodes 10 and 11 are formed by performing printing using the paste composition for an electrode according to the present invention into the form of stripes, on the n⁺ diffusion layer 2 and the p⁺ diffusion layer 7, respectively. In a case in which the p⁺ diffusion layer 7 is formed using an aluminum paste, it is enough that back surface electrodes are formed using the paste composition for an electrode according to the present invention only on the n⁺ diffusion layer 2.

Subsequently, the paste composition is dried and then sintered in the atmosphere at approximately 450°C to 850°C, thereby forming light-receiving surface collecting electrodes 8, through-hole electrodes 9, and back surface electrodes 10 and 11. In a case in which an aluminum electrode is used for either one of the back surface electrodes, as mentioned above, it is also possible to form one of the back surface electrodes by performing printing and sintering of an aluminum paste, followed by printing, filling and sintering of the paste composition for an electrode according to the present invention, thereby forming light-receiving surface collecting electrodes 8, through-hole electrodes 9, and the other one of back surface electrodes, from the viewpoints of sintering properties of aluminum and ohmic contact properties of the back surface electrodes and the p⁺ diffusion layer 7.

A photovoltaic cell element having a structure shown in the perspective view of Fig. 6, may be produced in a similar manner to the production of a photovoltaic cell element having a structure shown in the perspective view of Fig. 5, except that the light-receiving surface collecting electrode is not formed. Specifically, in a photovoltaic cell element having a structure shown in the perspective view of Fig. 6, the paste composition for an electrode according to the present invention may be used for through-hole electrodes 9 and back surface electrodes 10 and 11.

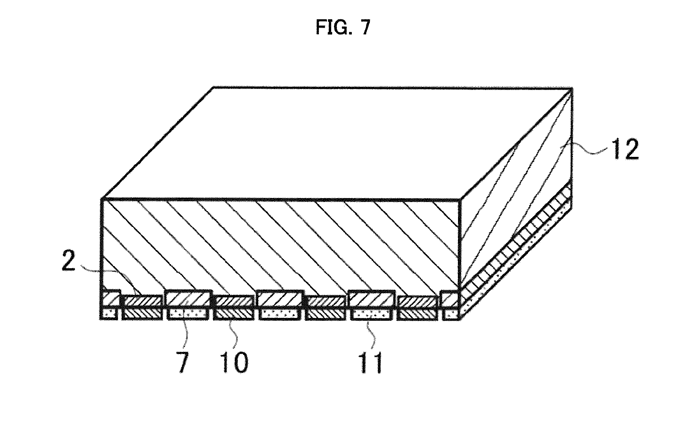

A photovoltaic cell element having a structure shown in the perspective view of Fig. 7, may be produced in a similar manner to the production of a photovoltaic cell element having a structure shown in the perspective view of Fig. 5, except that an n-type silicon substrate 12 is used as the substrate that serves as a base, and that no through-hole is formed. Specifically, in a photovoltaic cell element having a structure shown in the perspective view of Fig. 7, the paste composition for an electrode according to the present invention may be used for back surface electrodes 10 and 11.

Applications of the paste composition for an electrode according to the present invention are not limited to photovoltaic cell electrodes as described above, and suitable examples thereof include electrode wiring and shield wiring for plasma displays, ceramic capacitors, antenna circuits, sensor circuits of various types, and heat radiating materials for semiconductor devices.

In particular, the paste composition for an electrode according to the invention may be favorably used for forming electrodes on a substrate containing silicon.

### <Photovoltaic cell>

A photovoltaic cell according to the present invention includes at least one photovoltaic cell element described above and a tab wire that is positioned on an electrode of the photovoltaic cell element. The photovoltaic cell may have a structure that includes plural photovoltaic cell elements that are connected to each other with tab wires, and is sealed with a sealing material.

The tab wire and the sealing material are not particularly restricted, and may be selected from any products that are common in the art.

The entire contents of the disclosure of Japanese Patent Application No. 2011-090520 are incorporated by reference herein.

All publications, patent applications, and technical standards described in this specification are herein incorporated by reference to the same extent as if each individual publication, patent application, or technical standard was specifically and individually indicated to be incorporated by reference.

### EXAMPLES

The present invention will be described in more detail with reference to the examples. However, the present invention is not limited thereto. The expressions "part" and "%" are by mass, unless otherwise specified.

### [Example 1]

### (a) Preparation of paste composition for electrode

Phosphorus-containing copper alloy particles containing 7 mass% of phosphorus were prepared by an ordinary method, and were melted and powderized by a water atomization process. Then, the powder was dried and classified. The classified powder was blended, and subjected to deoxidation and dehydration treatments, thereby preparing phosphorus-containing copper alloy particles containing 7 mass% of phosphorus. The particle size (D50%) of the phosphorus-containing copper alloy particles was 5.0 µm, and the shape thereof was quasispherical.

A glass (hereinafter, also referred to "G01") composed of silicon dioxide (SiO₂) (3 parts), lead oxide (PbO) (60 parts), boron oxide (B₂O₃) (18 parts), bismuth oxide (Bi₂O₃) (5 parts), aluminum oxide (Al₂O₃) (5 parts), and zinc oxide (ZnO) (9 parts) was prepared. The obtained G01 had a softening point of 420°C and a crystallization temperature of higher than 650°C.

Using the obtained G01, glass G01 particles having a particle size (D50%) of 2.5 µm were produced. The shape of the particles was quasispherical.

The obtained phosphorus-containing copper alloy particles (39.9 parts), tin particles (Sn; particle size (D50%) of 10.0 µm; purity of 99.9%) (41.5 parts), glass G01 particles (4.1 parts), terpineol (Ter) (14.1 parts), and ethylcellulose (EC) (0.4 parts) were blended and milled in an agate mortar for 20 minutes, thereby preparing a paste composition for an electrode 1.

### (b) Production of photovoltaic cell element

A p-type semiconductor substrate having a thickness of 190 µm, in which an n⁺ diffusion layer, a texture and an antireflection coating (silicon nitride film) were formed on the light-receiving surface, was prepared. A specimen having a size of 125 mm×125 mm was cut out from the p-type semiconductor substrate. On the light-receiving surface, the paste composition for an electrode 1, obtained in the above process, was provided by a screen printing method to form an electrode pattern as shown in Fig. 2. Printing conditions (screen mesh size, printing speed, and printing pressure) were adjusted so that the electrode pattern include 150 µm-wide finger lines and 1.5 mm-wide bus bars, and have a thickness after sintering of 20 µm. The specimen was placed in an oven heated to 150°C for 15 minutes, to evaporate the solvent.

Next, an electrode pattern as shown in Fig. 3 was formed using the paste composition for an electrode 1 and an aluminum electrode paste by a screen printing method in the same manner as above.

The pattern of the back-surface power output electrode, formed from the paste composition for an electrode 1, was constituted of two electrodes each having a size of 123 mm×5 mm. The printing conditions (screen mesh size, printing speed, and printing pressure) were adjusted appropriately so that the thickness of the back surface power output electrode after sintering was 20 µm. The aluminum electrode paste was provided by printing on the whole surface except for the back surface power output electrodes, thereby forming a back-surface collecting electrode pattern. The printing conditions for the aluminum electrode paste were adjusted appropriately so that the thickness of the back-surface collecting electrode after sintering was 30 µm. The specimen was placed in an oven heated to 150°C for 15 minutes, and the solvent was allowed to evaporate.

Next, the p-type semiconductor substrate was subjected to a heat treatment (sintering) using a tunnel oven (single-line conveyer W/B tunnel oven, manufactured by Noritake Co., Limited) in the atmosphere for a retention time of 10 seconds at a maximum sintering temperature of 800°C, thereby preparing a photovoltaic cell element 1 having desired electrodes formed thereon.

### [Example 2]

A photovoltaic cell element 2 was produced in the same manner as in Example 1, except that the sintering conditions for forming an electrode was changed from 10 seconds at a maximum temperature of 800°C to 8 seconds at a maximum temperature of 850°C.

### [Example 3]

A photovoltaic cell element 3 was produced in the same manner as in Example 1, except that a paste composition for an electrode 3 was produced by changing the phosphorus content of the phosphorus-containing copper alloy particles from 7 mass% to 6 mass%.

### [Example 4]

A photovoltaic cell element 4 was produced in the same manner as in Example 3, except that the sintering conditions for forming an electrode was changed from 10 seconds at a maximum temperature of 800°C to 12 seconds at a maximum temperature of 750°C.

### [Example 5]

A photovoltaic cell element 5 was produced in the same manner as in Example 1, except that a paste composition for an electrode 5 was produced by changing the phosphorus content of the phosphorus-containing copper alloy particles from 7 mass% to 8 mass%.

### [Example 6]

A photovoltaic cell element 6 was produced in the same manner as in Example 1, except that a paste composition for an electrode 6 was prepared by changing the particle size (D50%) of the phosphorus-containing copper alloy particles from 5.0 µm to 1.5 µm.

### [Example 7]

A photovoltaic cell element 7 was produced in the same manner as in Example 1, except that a paste composition for an electrode 7 was prepared by changing the contents of the phosphorus-containing copper alloy particles and the tin-containing particles to 56.3 parts and 25.1 parts, respectively.

### [Example 8]

A photovoltaic cell element 8 was produced in the same manner as in Example 1, except that a paste composition for an electrode 8 was prepared by changing the contents of the phosphorus-containing copper alloy particles and the tin-containing particles to 73.0 parts and 8.4 parts, respectively.

### [Example 9]

A photovoltaic cell element 9 was produced in a similar manner to Example 1, except that a paste composition for an electrode 9 was prepared by using tin alloy particles composed of Sn-58Bi (Sn alloy containing 58 mass% of Bi) as the tin-containing particles instead of the tin particles (Sn), and by changing the particle size (D50%) thereof to 15.0 µm.

### [Example 10]

A photovoltaic cell element 10 was produced in the same manner as in Example 1, except that a paste composition for an electrode 10 was produced by using tin alloy particles composed of Sn-4Ag-0.5Cu (Sn alloy containing 4 mass% ofAg and 0.5 mass% of Cu) as the tin-containing particles instead of the tin particles (Sn), and by changing the particle size (D50%) thereof to 8.0 µm.

### [Example 11]

A photovoltaic cell element 11 was produced in the same manner as in Example 1, except that a paste composition for an electrode 11 was produced by changing the particle size (D50%) of the tin-containing particles from 10.0 µm to 6.0 µm.

### [Example 12]

A photovoltaic cell element 12 was produced in the same manner as in Example 1, except that a paste composition for an electrode 12 was prepared by adding silver particles (Ag; particle size (D50%) 3.0 µm; purity 99.5%) to the paste composition for an electrode of Example 1. More specifically, the contents of the components were changed to 37.9 parts for the phosphorus-containing copper alloy particles, 39.5 parts for the tin particles, 4.0 parts for the silver particles, 4.1 parts for the glass G01 particles, 14.1 parts for terpineol, and 0.4 parts for ethyl cellulose.

### [Example 13]

A photovoltaic cell element 13 was produced in the same manner as in Example 1, except that a paste composition for an electrode 13 was prepared by adding silver particles (Ag; particle size (D50%) 3.0 µm) to the paste composition for an electrode of Example 1. More specifically, the contents of the components were changed to 36.9 parts for the phosphorus-containing copper alloy particles, 38.4 parts for the tin particles, 6.1 parts for the silver particles, 4.1 parts for the glass G01 particles, 14.1 parts for terpineol, and 0.4 parts for ethyl cellulose.

### [Example 14]

A paste composition for an electrode 14 was produced in the same manner as in Example 1, except that a paste composition for an electrode 14 was prepared by changing the content of the glass G01 particles used. More specifically, the contents of the components were changed to 38.3 parts for the phosphorus-containing copper alloy particles, 39.9 parts for the tin particles, 7.8 parts for the glass G01 particles, 13.5 parts for terpineol, and 0.4 parts for ethyl cellulose.

### [Example 15]

A photovoltaic cell element 15 was produced in the same manner as in Example 1, except that a paste composition for an electrode 15 was produced by changing the composition of the glass particles from G01 to G02 as described below.

A glass G02 was prepared such that the content of vanadium oxide (V₂O₅) was 45 parts, phosphorus oxide (P₂O₅) was 24.2 parts, barium oxide (BaO) was 20.8 parts, antimony oxide (Sb₂O₃) was 5 parts, and tungsten oxide (WO₃) was 5 parts. The softening point of the glass G02 was 492°C, and the crystallization initiation temperature thereof was higher than 650°C.

Using the obtained glass G02, glass G02 particles having a particle size (D50%) of 2.5 µm was prepared. The shape thereof was quasispherical.

### [Example 16]

A photovoltaic cell element 16 was produced in the same manner as in Example 1, except that a paste composition for an electrode 16 was prepared by changing the solvent from terpineol to diethylene glycol monobutyl ether (BC), and changing the resin from ethyl cellulose to poly(ethyl acrylate) (EPA). More specifically, the contents of the components were changed to 39.9 parts for the phosphorus-containing copper alloy particles, 41.5 parts for the tin particles, 4.1 parts for the glass G01 particles, 12.3 parts for diethylene glycol monobutyl ether, and 2.2 parts for poly(ethyl acrylate).

### [Examples 17 to 20]

Paste compositions for an electrode 17 to 20 were prepared in the same manner as in Example 1, respectively, by changing the phosphorus content, the particle size (D50%) and the content of the phosphorus-containing copper alloy particles; the composition, the particle size (D50%) and the content of the tin-containing particles; the content of the silver particles; the type and the content of the glass particles; the type and the content of the solvent; and the type and the content of the resin, to those as shown in Tables 1-1 to 1-4, respectively.

Using the obtained paste compositions for an electrode 17 to 20, photovoltaic cell elements 17 to 20, on which an intended electrode was formed, were produced in the same manner as in Example 1, respectively, except that the temperature and the treatment time for the heat treatment were changed to those as shown in Tables 1-1 to 1-4.

### [Example 21]

A p-type semiconductor substrate having a thickness of 190 µm, in which an n⁺ diffusion layer, a texture, and an antireflection coating (silicon nitride film) were formed on the light-receiving surface, was prepared. A specimen having a size of 125 mm×125 mm was cut out from the p-type semiconductor substrate. Thereafter, on the back surface of the p-type semiconductor substrate, a back-surface collecting electrode pattern was formed by printing using an aluminum electrode paste. The back-surface collecting pattern was formed on the entire region except for the regions in which the back-surface power output electrode was formed, as shown in Fig. 3. Printing conditions for the aluminum electrode paste were appropriately adjusted such that the back-surface collecting electrode had a thickness after sintering of 30 µm. The specimen was placed in an oven heated to 150°C for 15 minutes, and the solvent was allowed to evaporate.

Next, the p-type semiconductor substrate was subjected to a heat treatment (sintering) using a tunnel oven (single-line conveyer W/B tunnel oven, manufactured by Noritake Co., Limited) in the atmosphere for a retention time of 10 seconds at a maximum sintering temperature of 800°C, thereby forming a back-surface collecting electrode and a p+ diffusion layer.

Next, electrode patterns as shown in Fig. 2 and Fig. 3 were formed by printing using the paste composition for an electrode 1 obtained as described above. The electrode pattern on the light-receiving surface was constituted of 150 µm-wide finger lines and 1.5 mm-wide bus bars, and the printing conditions (screen mesh size, printing speed, and printing pressure) were adjusted appropriately such that the thickness after sintering was 20 µm. The pattern of the back surface electrode was 123 mm×5 mm in size and 20 µm in thickness, and was printed at two portions. The specimen was placed in an oven heated to 150°C for 15 minutes to allow the solvent to evaporate.

Next, the obtained specimen was subjected to a heat treatment (sintering) using a tunnel oven (single-line conveyer W/B tunnel oven, manufactured by Noritake Co., Limited) in the atmosphere for a retention time of 10 seconds at a maximum sintering temperature of 650°C, thereby preparing a photovoltaic cell element 21 having desired electrodes formed thereon.

### [Example 22]

A photovoltaic cell element 22 was produced in the same manner as in Example 21, except that the paste composition for an electrode 5 was used for forming the light-receiving surface electrode and the back-surface power output electrode, respectively.

### [Example 23]

A photovoltaic cell element 23 was produced in the same manner as in Example 21, except that the paste composition for an electrode 9 was used for forming the light-receiving surface electrode and the back-surface power output electrode, and that the sintering conditions for forming the electrodes were changed from 10 seconds at a maximum temperature of 650°C to 10 seconds at a maximum temperature of 620°C.

### [Example 24]

A photovoltaic cell element 24 having a structure as shown in Fig. 5 was produced using the paste composition for an electrode 1 obtained as described above. Specific productions method will be described below.

First, through-holes penetrating from the light-receiving surface side to the back surface side, and having a diameter of 100 µm, were formed in a p-type silicon substrate using a laser drill. Further, a texture, an n⁺ diffusion layer, and an antireflection coating were formed on the light-receiving surface side, in this order. The n⁺ diffusion layer was formed also on inner sides of the through holes and a portion of the back surface. Then, the formed through-holes were filled with the paste composition for an electrode 1 by an inkjet method, and a grid pattern was formed by printing using the paste composition for an electrode 1 on the light-receiving surface side.

On the back surface side, a striped pattern shown in Fig. 4 was printed using the paste composition for an electrode 1 and an aluminum electrode paste, such that the paste composition for an electrode 1 was printed below the through-holes. The resultant was subjected to a heat treatment using a tunnel oven (single-line WB conveyor tunnel oven, manufactured by Noritake Co., Limited) in the atmosphere for a retention time of 10 seconds at a maximum sintering temperature of 800°C, thereby producing a photovoltaic cell element 24 having desired electrodes formed thereon.

At this time, during sintering, aluminum was allowed to diffuse into the p-type silicon substrate in a region in which the aluminum electrode paste had been formed, whereby a p⁺ diffusion layer was formed.

### [Example 25]

A photovoltaic cell element 25 was produced in the same manner as in Example 24, except that the light-receiving surface collecting electrode, the through-hole electrode, and the back surface electrode were formed using the paste composition for an electrode 12 obtained as described above, instead of the paste composition for an electrode 1 used in Example 24.

### [Example 26]

A photovoltaic cell element 26 was produced in the same manner as in Example 24, except that the sintering conditions for forming the electrode were changed from 10 seconds at a maximum temperature of 800°C to 8 seconds at a maximum temperature of 850°C.

### [Example 27]

A photovoltaic cell element 27 was produced in the same manner as in Example 24, except that the light-receiving surface collecting electrode, the through-hole electrode, and the back surface electrode were formed using the paste composition for an electrode 9 obtained as described above, instead of the paste composition for an electrode 1 used in Example 24.

### [Example 28]

A paste composition for an electrode 28 was prepared in the same manner as in Example 1, except that the glass particles were changed from the glass G01 particles to glass G03 particles.

The glass G03 was prepared to have a composition in which silicon dioxide (SiO₂) was 13 parts, boron oxide (B₂O₃) was 58 parts, zinc oxide (ZnO) was 38 parts, aluminum oxide (Al₂O₃) was 12 parts, and barium oxide (BaO) was 12 parts. The softening point of the obtained glass G03 was 583°C, and the crystallization initiation temperature thereof was higher than 650°C.

Using the obtained glass G03, glass G03 particles having a particle size (D50%) of 2.5 µm were obtained. The shape thereof was quasispherical.

Subsequently, a photovoltaic cell element 28, having a structure as shown in Fig. 6, was produced using the thus-obtained paste composition for an electrode 28. The production method therefor is substantially the same as in Examples 24 to 27, except that the light-receiving surface electrode was not formed. The sintering was carried out for a retention time of 10 seconds at a maximum temperature of 800°C.

### [Example 29]

A photovoltaic cell element 29 was produced in the same manner as in Example 28, except that the sintering conditions for forming an electrode was changed from 10 seconds at a maximum temperature of 800°C to 8 seconds at a maximum temperature of 850°C.

### [Example 30]

A photovoltaic cell element 30, having a structure as shown in Fig. 7, was produced using the paste composition for an electrode 28 obtained as described above. The production method therefor was substantially the same as in Example 24, except that an n-type silicon substrate was used as a basic substrate, and that the light-receiving surface electrode, the through-holes and the through-hole electrodes were not formed. The sintering was carried out for a retention time of 10 seconds at a maximum temperature of 800°C.

### [Example 31]

A paste composition for an electrode 31 was prepared in the same manner as in Example 5, except that the glass particles were changed from the glass G01 particles to the glass G03 particles. Then, a photovoltaic cell element 31 having a structure shown in Fig. 7 was produced in the same manner as in Example 30, except that the paste composition for an electrode 31 was used.

### [Example 32]

A paste composition 32 for an electrode was prepared in the same manner as in Example 12, except that the glass particles were changed from the glass G01 particles to the glass G03 particles. A photovoltaic cell element 32 having a structure shown in Fig. 7 was produced in a similar manner to Example 30, except that the paste composition for an electrode 32 was used.

### [Comparative Example 1]

A paste composition for an electrode C1 was prepared in the same manner as in Example 1, except that the phosphorus-containing copper alloy particles and the tin-containing particles were not used and the components of the paste composition for an electrode 1 used in Example 1 were changed to those shown in Tables 1-1 to 1-4.

A photovoltaic cell element C1 was produced in the same manner as in Example 1, except that the paste composition for an electrode C1 not containing the phosphorus-containing copper alloy particles and the tin-containing particles was used.

### [Comparative Examples 2 to 4]

Paste compositions for an electrode C2 to C4 having the compositions as shown in Tables 1-1 to 1-4 were prepared, respectively, in which phosphorus-containing copper alloy particles having different phosphorus contents were used and tin-containing particles were not used.

Photovoltaic cell elements C2 to C4 were produced in the same manner as in Comparative Example 1, except that the paste compositions for an electrode C2 to C4 were used, respectively.

### [Comparative Example 5]

A paste composition for an electrode C5 was prepared in the same manner as in Example 1, except that copper particles (purity: 99.5%, particle size (D50%): 5.0 µm, content: 39.9 parts) were used instead of the phosphorus-containing copper alloy particles used in the preparation of the paste composition for an electrode of Example 1, and that the respective components were changed to the compositions as shown in Tables 1-1 to 1-4.

A photovoltaic cell element C5 was produced in the same manner as in Comparative Example 1, except that the paste composition for an electrode C5 was used.

### [Comparative Example 6]

A photovoltaic cell element C6 was produced in the same manner as in Example 24, except that the light-receiving surface collecting electrode, the through-hole electrodes, and the back surface electrodes were formed using the paste composition for an electrode C1 obtained as described above, instead of the paste composition for an electrode 1 used in Example 24.

### [Comparative Example 7]

A photovoltaic cell element C7 was produced in the same manner as in Example 28, except that the paste composition for an electrode 28 was changed to the paste composition for an electrode C1 obtained as described above.

### [Comparative Example 8]

A photovoltaic cell element C8 was produced in the same manner as in Example 30, except that the paste composition for an electrode 28 was changed to the paste composition for an electrode C1 obtained as described above.

**Table 1-1**

| | Phosphorus-containing copper alloy particles | | | Tin-containing particles | | | Silver particles | | Glass particles | | | Solvent | | Resin | |
|---|---|---|---|---|---|---|---|---|---|---|---|---|---|---|---|
| | Phosphorus content (wt%) | Particle size (D50%) (µm) | Content (part) | Composition | Particle size (D50%) (µm) | Content (part) | Particle size (D50%) (µm) | Content (part) | Type | Particle size (D50%) (µm) | Content (part) | Type | Content (part) | Type | Content (part) |
| Example 1 | 7 | 5.0 | 39.9 | Sn | 10.0 | 41.5 | - | 0.0 | G01 | 2.5 | 4.1 | Ter | 14.1 | EC | 0.4 |
| Example 2 | 7 | 5.0 | 39.9 | Sn | 10.0 | 41.5 | - | 0.0 | G01 | 2.5 | 4.1 | Ter | 14.1 | EC | 0.4 |
| Example 3 | 6 | 5.0 | 39.9 | Sn | 10.0 | 41.5 | - | 0.0 | G01 | 2.5 | 4.1 | Ter | 14.1 | EC | 0.4 |
| Example 4 | 6 | 5.0 | 39.9 | Sn | 10.0 | 41.5 | - | 0.0 | G01 | 2.5 | 4.1 | Ter | 14.1 | EC | 0.4 |
| Example 5 | 8 | 5.0 | 39.9 | Sn | 10.0 | 41.5 | - | 0.0 | G01 | 2.5 | 4.1 | Ter | 14.1 | EC | 0.4 |
| Example 6 | 7 | 1.5 | 39.9 | Sn | 10.0 | 41.5 | - | 0.0 | G01 | 2.5 | 4.1 | Ter | 14.1 | EC | 0.4 |
| Example 7 | 7 | 5.0 | 56.3 | Sn | 10.0 | 25.1 | - | 0.0 | G01 | 2.5 | 4.1 | Ter | 14.1 | EC | 0.4 |
| Example 8 | 7 | 5.0 | 73.0 | Sn | 10.0 | 8.4 | - | 0.0 | G01 | 2.5 | 4.1 | Ter | 14.1 | EC | 0.4 |
| Example 9 | 7 | 5.0 | 39.9 | Sn-58Bi | 15.0 | 41.5 | - | 0.0 | G01 | 2.5 | 4.1 | Ter | 14.1 | EC | 0.4 |
| Example 10 | 7 | 5.0 | 39.9 | Sn-4Ag-0.5C u | 8.0 | 41.5 | - | 0.0 | G01 | 2.5 | 4.1 | Ter | 14.1 | EC | 0.4 |
| Example 11 | 7 | 5.0 | 39.9 | Sn | 6.0 | 41.5 | - | 0.0 | G01 | 2.5 | 4.1 | Ter | 14.1 | EC | 0.4 |
| Example 12 | 7 | 5.0 | 37.9 | Sn | 10.0 | 39.5 | 3.0 | 4.0 | G01 | 2.5 | 4.1 | Ter | 14.1 | EC | 0.4 |
| Example 13 | 7 | 5.0 | 36.9 | Sn | 10.0 | 38.4 | 3.0 | 6.1 | G01 | 2.5 | 4.1 | Ter | 14.1 | EC | 0.4 |
| Example 14 | 7 | 5.0 | 38.3 | Sn | 10.0 | 39.9 | - | 0.0 | G01 | 2.5 | 7.8 | Ter | 13.5 | EC | 0.4 |
| Example 15 | 7 | 5.0 | 39.9 | Sn | 10.0 | 41.5 | - | 0.0 | G02 | 2.5 | 4.1 | Ter | 14.1 | EC | 0.4 |
| Example 16 | 7 | 5.0 | 39.9 | Sn | 10.0 | 41.5 | - | 0.0 | G01 | 2.5 | 4.1 | BC | 12.3 | EPA | 2.2 |
| Example 17 | 6 | 5.0 | 56.1 | Sn | 6.0 | 21.4 | 3.0 | 4.0 | G01 | 2.5 | 4.1 | BC | 13.6 | EPA | 0.9 |
| Example 18 | 7 | 5.0 | 44.9 | Sn-4Ag-0.5C u | 15.0 | 34.5 | - | 0.0 | G02 | 2.5 | 6.1 | Ter | 14.1 | EC | 0.4 |
| Example 19 | 8 | 1.5 | 61.1 | Sn-58Bi | 15.0 | 12.2 | 3.0 | 6.1 | G01 | 2.5 | 6.1 | Ter | 14.1 | EC | 0.4 |
| Example 20 | 7 | 1.5 | 30.4 | Sn | 10.0 | 45.7 | 3.0 | 5.5 | G02 | 2.5 | 4.0 | BC | 12.3 | EPA | 2.2 |
| Example 21 | 7 | 5.0 | 39.9 | Sn | 10.0 | 41.5 | - | 0.0 | G01 | 2.5 | 4.1 | Ter | 14.1 | EC | 0.4 |
| Example 22 | 8 | 5.0 | 39.9 | Sn | 10.0 | 41.5 | - | 0.0 | G01 | 2.5 | 4.1 | Ter | 14.1 | EC | 0.4 |
| Example 23 | 7 | 5.0 | 39.9 | Sn-58Bi | 15.0 | 41.5 | - | 0.0 | G01 | 2.5 | 4.1 | Ter | 14.1 | EC | 0.4 |
| Example 24 | 7 | 5.0 | 39.9 | Sn | 10.0 | 41.5 | - | 0.0 | G01 | 2.5 | 4.1 | Ter | 14.1 | EC | 0.4 |
| Example 25 | 7 | 5.0 | 37.9 | Sn | 10.0 | 39.5 | 3.0 | 4.0 | G01 | 2.5 | 4.1 | Ter | 14.1 | EC | 0.4 |
| Example 26 | 7 | 5.0 | 39.9 | Sn | 10.0 | 41.5 | - | 0.0 | G01 | 2.5 | 4.1 | Ter | 14.1 | EC | 0.4 |
| Example 27 | 7 | 5.0 | 39.9 | Sn-58Bi | 15.0 | 41.5 | - | 0.0 | G01 | 2.5 | 4.1 | Ter | 14.1 | EC | 0.4 |
| Example 28 | 7 | 5.0 | 39.9 | Sn | 10.0 | 41.5 | - | 0.0 | G03 | 2.5 | 4.1 | Ter | 14.1 | EC | 0.4 |
| Example 29 | 7 | 5.0 | 39.9 | Sn | 10.0 | 41.5 | - | 0.0 | G03 | 2.5 | 4.1 | Ter | 14.1 | EC | 0.4 |
| Example 30 | 7 | 5.0 | 39.9 | Sn | 10.0 | 41.5 | - | 0.0 | G03 | 2.5 | 4.1 | Ter | 14.1 | EC | 0.4 |
| Example 31 | 8 | 5.0 | 39.9 | Sn | 10.0 | 41.5 | - | 0.0 | G03 | 2.5 | 4.1 | Ter | 14.1 | EC | 0.4 |
| Example 32 | 7 | 5.0 | 37.9 | Sn | 10.0 | 39.5 | 3.0 | 4.0 | G03 | 2.5 | 4.1 | Ter | 14.1 | EC | 0.4 |

**Table 1-2**

| | Phosphorus-containing copper alloy particles | | | Tin-containing particles | | | Silver particles | | Glass particles | | | Solvent | | Resin | |
|---|---|---|---|---|---|---|---|---|---|---|---|---|---|---|---|
| | Phosphorus content (wt%) | Particle size (D50%) (µm) | Content (part) | Composition | Particle size (D50%) (µm) | Content (part) | Particle size (D50%) (µm) | Content (part) | Type | Particle size (D50%) (µm) | Content (part) | Type | Content (part) | Type | Content (part) |
| Comparative Example 1 | - | - | - | - | - | - | 3.0 | 81.4 | G01 | 2.5 | 4.1 | Ter | 14.1 | EC | 0.4 |
| Comparative Example 2 | 0 | 5.0 | 81.4 | - | - | - | - | - | G01 | 2.5 | 4.1 | Ter | 14.1 | EC | 0.4 |
| Comparative Example 3 | 1 | 5.0 | 81.4 | - | - | - | - | - | G01 | 2.5 | 4.1 | Ter | 14.1 | EC | 0.4 |
| Comparative Example 4 | 7 | 5.0 | 81.4 | - | - | - | - | - | G01 | 2.5 | 4.1 | Ter | 14.1 | EC | 0.4 |
| Comparative Example 5 | 0 | 5.0 | 39.9 | Sn | 10.0 | 41.5 | - | - | G01 | 2.5 | 4.1 | Ter | 14.1 | EC | 0.4 |
| Comparative Example 6 | - | - | - | - | - | - | 3.0 | 81.4 | G01 | 2.5 | 4.1 | Ter | 14.1 | EC | 0.4 |
| Comparative Example 7 | - | - | - | - | - | - | 3.0 | 81.4 | G01 | 2.5 | 4.1 | Ter | 14.1 | EC | 0.4 |
| Comparative Example 8 | - | - | - | - | - | - | 3.0 | 81.4 | G01 | 2.5 | 4.1 | Ter | 14.1 | EC | 0.4 |

**Table 1-3**

| | Photovoltaic cell structure | Applied electrode | | | | | Only A1 electrode formed | Sintering conditions for Al paste | | Sintering conditions for paste composition for electrode | |
|---|---|---|---|---|---|---|---|---|---|---|---|
| | | Light-receiving surface collecting electrode | Light-receiving surface power output electrode | Back surface power output electrode | Through-hole electrode | Back surface electrode | | Maximum temperature [°C] | Retention time [sec] | Maximum temperature [°C] | Retention time [sec] |
| Example 1 | Double-sided | ○ | ○ | ○ | - | - | - | - | - | 800 | 10 |
| Example 2 | Double-sided | ○ | ○ | ○ | - | - | - | - | - | 850 | 8 |
| Example 3 | Double-sided | ○ | ○ | ○ | - | - | - | - | - | 800 | 10 |
| Example 4 | Double-sided | ○ | ○ | ○ | - | - | - | - | - | 750 | 12 |
| Example 5 | Double-sided | ○ | ○ | ○ | - | - | - | - | - | 800 | 10 |
| Example 6 | Double-sided | ○ | ○ | ○ | - | - | - | - | - | 800 | 10 |
| Example 7 | Double-sided | ○ | ○ | ○ | - | - | - | - | - | 800 | 10 |
| Example 8 | Double-sided | ○ | ○ | ○ | - | - | - | - | - | 800 | 10 |
| Example 9 | Double-sided | ○ | ○ | ○ | - | - | - | - | - | 800 | 10 |
| Example 10 | Double-sided | ○ | ○ | ○ | - | - | - | - | - | 800 | 10 |
| Example 11 | Double-sided | ○ | ○ | ○ | - | - | - | - | - | 800 | 10 |
| Example 12 | Double-sided | ○ | ○ | ○ | - | - | - | - | - | 800 | 10 |
| Example 13 | Double-sided | ○ | ○ | ○ | - | - | - | - | - | 800 | 10 |
| Example 14 | Double-sided | ○ | ○ | ○ | - | - | - | - | - | 800 | 10 |
| Example 15 | Double-sided | ○ | ○ | ○ | - | - | - | - | - | 800 | 10 |
| Example 16 | Double-sided | ○ | ○ | ○ | - | - | - | - | - | 800 | 10 |
| Example 17 | Double-sided | ○ | ○ | ○ | - | - | - | - | - | 800 | 10 |
| Example 18 | Double-sided | ○ | ○ | ○ | - | - | - | - | - | 750 | 12 |
| Example 19 | Double-sided | ○ | ○ | ○ | - | - | - | - | - | 800 | 10 |
| Example 20 | Double-sided | ○ | ○ | ○ | - | - | - | - | - | 850 | 8 |
| Example 21 | Double-sided | ○ | ○ | ○ | - | - | ○ | 800 | 10 | 650 | 10 |
| Example 22 | Double-sided | ○ | ○ | ○ | - | - | ○ | 800 | 10 | 650 | 10 |
| Example 23 | Double-sided | ○ | ○ | ○ | - | - | ○ | 800 | 10 | 620 | 10 |
| Example 24 | Back-contact | ○ | - | - | ○ | ○ | - | - | - | 800 | 10 |
| Example 25 | Back-contact | ○ | - | - | ○ | ○ | - | - | - | 800 | 10 |
| Example 26 | Back-contact | ○ | - | - | ○ | ○ | - | - | - | 850 | 8 |
| Example 27 | Back-contact | ○ | - | - | ○ | ○ | - | - | - | 800 | 10 |
| Example 28 | Back-contact | - | - | - | ○ | ○ | - | - | - | 800 | 10 |
| Example 29 | Back-contact | - | - | - | ○ | ○ | - | - | - | 850 | 8 |
| Example 30 | Back-contact | - | - | - | - | ○ | - | - | - | 800 | 10 |
| Example 31 | Back-contact | - | - | - | - | ○ | - | - | - | 800 | 10 |
| Example 32 | Back-contact | - | - | - | - | ○ | - | - | - | 800 | 10 |

**Table 1-4**

| | Photovoltaic cell structure | Applied electrode | | | | | Only Al electrode formed | Sintering conditions for Al paste | | Sintering conditions for paste composition for electrode | |
|---|---|---|---|---|---|---|---|---|---|---|---|
| | | Light-receiving surface collecting electrode | Light-receiving surface power output electrode | Back surface power output electrode | Through-hole electrode | Back surface electrode | | Maximum temperature [°C] | Retention time [sec] | Maximum temperature [°C] | Retention time [sec] |
| Comparative Example 1 | Double-sided | ○ | ○ | ○ | - | - | - | - | - | 800 | 10 |
| Comparative Example 2 | Double-sided | ○ | ○ | ○ | - | - | - | - | - | 800 | 10 |
| Comparative Example 3 | Double-sided | ○ | ○ | ○ | - | - | - | - | - | 800 | 10 |
| Comparative Example 4 | Double-sided | ○ | ○ | ○ | - | - | - | - | - | 800 | 10 |
| Comparative Example 5 | Double-sided | ○ | ○ | ○ | - | - | - | - | - | 800 | 10 |
| Comparative Example 6 | Back-contact | ○ | - | - | ○ | ○ | - | - | - | 800 | 10 |
| Comparative Example 7 | Back-contact | - | - | - | ○ | ○ | - | - | - | 800 | 10 |
| Comparative Example 8 | Back-contact | - | - | - | - | ○ | - | - | - | 800 | 10 |

### [Evaluation]

Evaluation of the produced photovoltaic cell elements was carried out using a combination of artificial sunlight (WXS-155S-10, trade name, manufactured by Wacom Electric Co., Ltd.) and a current-voltage (I-V) analyzer (I-V CURVE TRACER MP-160, trade name, manufactured by EKO Instruments Co., Ltd.).

Jsc (short circuit current), Voc (open-circuit voltage), FF (fill factor), and Eff (conversion efficiency), which indicate photovoltaic performances of a photovoltaic cell, were obtained by measurements according to JIS-C-8912, JIS-C-8913 and JIS-C-8914. The measured values of photovoltaic cell elements having a double-surface electrode structure were reduced to relative values, based on the measure values for Comparative Example 1 (photovoltaic cell element C1) that are defined as 100.0. The results are shown in Tables 2-1 to 2-2. In Comparative Example 2, evaluation was not possible to carry out due to increased resistivity of the electrode caused by oxidation of copper particles.

Further, a cross-section of the light-receiving surface electrodes, formed by sintering the paste composition for an electrode, was observed using a scanning electron microscope (MINISCOPE TM-1000, trade name, manufactured by Hitachi, Ltd.) with an acceleration voltage of 15 kV, to investigate the existence or nonexistence of a Cu-Sn alloy phase and an Sn-P-O glass phase in the electrode, and the location of the Sn-P-O glass phase. The results are shown in Tables 2-1 to 2-2.

**Table 2-1**

| | Photovoltaic performances as photovoltaic cell | | | | Observation of electrode cross-section | | |
|---|---|---|---|---|---|---|---|
| | Jsc (relative value) short circuit current | Voc (relative value) open-circuit voltage | F.F. (relative value) fill factor | Eff (relative value) conversion efficiency | Cu-Sn alloy phase | Sn-P-O glass phase | |
| | | | | | Existence or Nonexistence | Existence or Nonexistence | Formed location |
| Example 1 | 100.2 | 100.4 | 99.9 | 100.3 | Existent | Existent | Between Cu-Sn alloy phase/Si substrate |
| Example 2 | 98.7 | 99.6 | 99.8 | 98.9 | Existent | Existent | Between Cu-Sn alloy phase/Si substrate |
| Example 3 | 99.4 | 98.2 | 100.1 | 98.7 | Existent | Existent | Between Cu-Sn alloy phase/Si substrate |
| Example 4 | 101.1 | 99.2 | 100.0 | 100.2 | Existent | Existent | Between Cu-Sn alloy phase/Si substrate |
| Example 5 | 102.2 | 99.4 | 100.3 | 99.4 | Existent | Existent | Between Cu-Sn alloy phase/Si substrate |
| Example 6 | 99.6 | 100.2 | 101.3 | 100.7 | Existent | Existent | Between Cu-Sn alloy phase/Si substrate |
| Example 7 | 99.7 | 98.2 | 97.7 | 98.9 | Existent | Existent | Between Cu-Sn alloy phase/Si substrate |
| Example 8 | 97.4 | 95.4 | 94.9 | 93.9 | Existent | Existent | Between Cu-Sn alloy phase/Si substrate |
| Example 9 | 99.7 | 100.2 | 99.9 | 100.0 | Existent | Existent | Between Cu-Sn alloy phase/Si substrate |
| Example 10 | 101.9 | 99.4 | 100.2 | 100.8 | Existent | Existent | Between Cu-Sn alloy phase/Si substrate |
| Example 11 | 101.0 | 99.8 | 98.7 | 99.9 | Existent | Existent | Between Cu-Sn alloy phase/Si substrate |
| Example 12 | 102.4 | 99.8 | 101.1 | 100.6 | Existent | Existent | Between Cu-Sn alloy phase/Si substrate |
| Example 13 | 103.3 | 100.9 | 102.1 | 100.1 | Existent | Existent | Between Cu-Sn alloy phase/Si substrate |
| Example 14 | 98.2 | 100.2 | 99.1 | 98.7 | Existent | Existent | Between Cu-Sn alloy phase/Si substrate |
| Example 15 | 98.4 | 99.3 | 99.4 | 98.7 | Existent | Existent | Between Cu-Sn alloy phase/Si substrate |
| Example 16 | 101.0 | 100.3 | 100.0 | 100.5 | Existent | Existent | Between Cu-Sn alloy phase/Si substrate |
| Example 17 | 99.4 | 100.2 | 100.2 | 99.6 | Existent | Existent | Between Cu-Sn alloy phase/Si substrate |
| Example 18 | 100.8 | 100.1 | 99.9 | 99.8 | Existent | Existent | Between Cu-Sn alloy phase/Si substrate |
| Example 19 | 97.8 | 95.5 | 94.3 | 95.9 | Existent | Existent | Between Cu-Sn alloy phase/Si substrate |
| Example 20 | 99.9 | 100.2 | 98.9 | 100.1 | Existent | Existent | Between Cu-Sn alloy phase/Si substrate |
| Example 21 | 101.1 | 100.3 | 100.2 | 101.1 | Existent | Existent | Between Cu-Sn alloy phase/Si substrate |
| Example 22 | 101.9 | 100.7 | 100.3 | 99.8 | Existent | Existent | Between Cu-Sn alloy phase/Si substrate |
| Example 23 | 99.2 | 100.1 | 99.4 | 99.4 | Existent | Existent | Between Cu-Sn alloy phase/Si substrate |

**Table 2-2**

| | Photovoltaic performances as photovoltaic cell | | | | Observation of electrode cross-section | | |
|---|---|---|---|---|---|---|---|
| | Jsc (relative value) short circuit current | Voc (relative value) open-circuit voltage | F.F. (relative value) fill factor | Eff (relative value) conversion efficiency | Cu-Sn alloy phase | Sn-P-O glass phase | |
| | | | | | Existence or Nonexistence | Existence or Nonexistence | Formed location |
| Comparative Example 1 | 100.0 | 100.0 | 100.0 | 100.0 | - | - | - |
| Comparative Example 2 | - | - | - | - | Not existent | Not existent | - |
| Comparative Example 3 | 33.4 | 48.8 | 39.8 | 6.6 | Not existent | Not existent | - |
| Comparative Example 4 | 45.0 | 42.1 | 41.2 | 20.1 | Not existent | Not existent | - |
| Comparative Example 5 | 10.4 | 20.1 | 26.0 | 19.0 | Not existent | Not existent | - |

As shown in Tables 2-1 to 2-2, the photovoltaic performances observed in Comparative Examples 3 to 5 were inferior to those of Comparative Example 1.

This is considered, for example, as follows. Comparative Example 4, not including tin-containing particles, caused interdiffusion of a silicon substrate and copper during sintering, thereby deteriorating the pn-junction characteristic in the substrate. It is also considered that Comparative Example 5, in which phosphorus-containing copper alloy particles were not used and pure copper (phosphorus content: 0 mass%) was used, caused oxidation of copper particles prior to reacting with tin-containing particles during sintering, whereby a Cu-Sn alloy phase was not formed and resistance of the electrode was increased.

On the other hand, the photovoltaic performances of the photovoltaic cell elements of Examples 1 to 23 were substantially equal to that of Comparative Example 1. In particular, the photovoltaic cell elements 21 to 23, although the paste compositions for an electrode were sintered at a relatively low temperature (620 to 650°C), exhibited high photovoltaic performances. Further, it was observed that a Cu-Sn alloy phase and an Sn-P-O glass phase were present in the light-receiving surface electrodes, and that the Sn-P-O glass phase was formed between the Cu-Sn alloy phase and the silicon substrate.

The measured values of the back-contact type photovoltaic cell elements having the structure of Fig. 5 were reduced to relative values based on the measured values of Comparative Example 6 that were defined as 100.0. The results are shown in Table 3. Further, the results of observation of a cross-section of the light-receiving surface electrode were shown in Table 3.

**Table 3**

| | Photovoltaic performances as photovoltaic cell | | | | Observation of electrode cross-section | | |
|---|---|---|---|---|---|---|---|
| | Jsc (relative value) short circuit current | Voc (relative value) open-circuit voltage | F.F. (relative value) fill factor | Eff (relative value) conversion efficiency | Cu-Sn alloy phase | Sn-P-O glass phase | |
| | | | | | Existence or Nonexistence | Existence or Nonexistence | Formed location |
| Example 24 | 99.3 | 99.8 | 98.7 | 99.2 | Existent | Existent | Between Cu-Sn alloy phase/Si substrate |
| Example 25 | 100.4 | 100.2 | 99.8 | 100.1 | Existent | Existent | Between Cu-Sn alloy phase/Si substrate |
| Example 26 | 98.8 | 98.2 | 98.9 | 99.2 | Existent | Existent | Between Cu-Sn alloy phase/Si substrate |
| Example 27 | 100.3 | 101.7 | 100.2 | 100.5 | Existent | Existent | Between Cu-Sn alloy phase/Si substrate |
| Comparative Example 6 | 100.0 | 100.0 | 100.0 | 100.0 | - | - | - |

As shown in Table 3, the photovoltaic performances of the photovoltaic cell elements of Examples 24 to 27 were substantially equal to that of Comparative Example 6. Further, it was observed that a Cu-Sn alloy phase and an Sn-P-O glass phase were present in the light-receiving surface electrodes, and that the Sn-P-O glass phase was formed between the Cu-Sn alloy phase and the silicon substrate.

The measured values of the back-contact type photovoltaic cell elements having the structure of Fig. 6 were reduced to relative values based on the measured values of Comparative Example 7 that were defined as 100.0. The results are shown in Table 4. Further, the results of observation of a cross-section of the light-receiving surface electrode were shown in Table 4.

**Table 4**

| | Photovoltaic performances as photovoltaic cell | | | | Observation of electrode cross-section | | |
|---|---|---|---|---|---|---|---|
| | Jsc (relative value) short circuit current | Voc (relative value) open-circuit voltage | F.F. (relative value) fill factor | Eff (relative value) conversion efficiency | Cu-Sn alloy phase | Sn-P-O glass phase | |
| | | | | | Existence or Nonexistence | Existence or Nonexistence | Formed location |
| Example 28 | 101.2 | 100.2 | 100.1 | 100.6 | Existent | Existent | Between Cu-Sn alloy phase/Si substrate |
| Example 29 | 99.8 | 100.1 | 99.7 | 99.5 | Existent | Existent | Between Cu-Sn alloy phase/Si substrate |
| Comparative Example 7 | 100.0 | 100.0 | 100.0 | 100.0 | - | - | - |

As shown in Table 4, the photovoltaic performances of the photovoltaic cell elements of Examples 28 to 29 were substantially equal to that of the photovoltaic cell element according to Comparative Example 7. Further, it was observed that a Cu-Sn alloy phase and an Sn-P-O glass phase were present in the back side electrodes formed by sintering the paste composition for an electrode, and that the Sn-P-O glass phase was formed between the Cu-Sn alloy phase and the silicon substrate.

The measured values of the back-contact type photovoltaic cell elements having the structure of Fig. 7 were reduced to relative values based on the measured values of Comparative Example 8 that were defined as 100.0. The results are shown in Table 5. Further, the results of observation of a cross-section of the light-receiving surface electrode were shown in Table 5.

**Table 5**

| | Photovoltaic performances as photovoltaic cell | | | | Observation of electrode cross-section | | |
|---|---|---|---|---|---|---|---|
| | Jsc (relative value) short circuit current | Voc (relative value) open-circuit voltage | F.F. (relative value) fill factor | Eff (relative value) conversion efficiency | Cu-Sn alloy phase | Sn-P-O glass phase | |
| | | | | | Existence or Nonexistence | Existence or Nonexistence | Formed location |
| Example 30 | 98.7 | 98.6 | 99.0 | 98.8 | Existent | Existent | Between Cu-Sn alloy phase/Si substrate |
| Example 31 | 99.1 | 99.2 | 98.3 | 98.3 | Existent | Existent | Between Cu-Sn alloy phase/Si substrate |
| Example 32 | 101.2 | 100.7 | 100.3 | 100.8 | Existent | Existent | Between Cu-Sn alloy phase/Si substrate |
| Comparative Example 8 | 100.0 | 100.0 | 100.0 | 100.0 | - | - | - |

As shown in Table 5, the photovoltaic performances of the photovoltaic cell elements of Examples 30 to 32 were substantially equal to that of the photovoltaic cell element according to Comparative Example 8. Further, it was observed that a Cu-Sn alloy phase and an Sn-P-O glass phase were present in the back side electrodes formed by sintering the paste composition for an electrode, and that the Sn-P-O glass phase was formed between the Cu-Sn alloy phase and the silicon substrate.

## Claims

1. A paste composition for an electrode, the paste composition comprising phosphorus-containing copper alloy particles, tin-containing particles, glass particles, a solvent and a resin.

2. The paste composition for an electrode according to claim 1, wherein a content of phosphorus in the phosphorus-containing copper alloy particles is from 6 mass% to 8 mass%.

3. The paste composition for an electrode according to claim 1 or claim 2, wherein the tin-containing particles comprise at least one selected from the group consisting of tin alloy particles in which a content of tin is 1 mass% or more and tin particles.

4. The paste composition for an electrode according to any one of claims 1 to 3, wherein the glass particles have a glass softening point of 650°C or less and a crystallization initiation temperature of higher than 650°C.

5. The paste composition for an electrode according to any one of claims 1 to 4, wherein a content of the tin-containing particles in a total content of the phosphorus-containing copper alloy particles and the tin-containing particles, which is defined as 100 mass%, is from 5 mass% to 70 mass%.

6. The paste composition for an electrode according to any one of claims 1 to 5, further comprising silver particles.

7. The paste composition for an electrode according to claim 6, wherein a content of the silver particles in a total content of the phosphorus-containing copper alloy particles, the tin-containing particles and the silver particles, which is defined as 100 mass%, is from 0.1 mass% to 10 mass%.

8. The paste composition for an electrode according to claim 6 or claim 7, wherein:
a total content of the phosphorus-containing copper alloy particles, the tin-containing particles and the silver particles is from 70 mass% to 94 mass% in the paste composition;
a content of the glass particles in the paste composition is from 0.1 mass% to 10 mass%; and
a total content of the solvent and the resin in the paste composition is from 3 mass% to 29.9 mass%.

9. A photovoltaic cell element comprising a silicon substrate and an electrode, the electrode being formed by sintering the paste composition for an electrode according to any one of claims 1 to 8 after it has been applied onto the silicon substrate.

10. The photovoltaic cell element according to claim 9, wherein the electrode comprises a Cu-Sn alloy phase and an Sn-P-O glass phase.

11. The photovoltaic cell element according to claim 10, wherein the Sn-P-O glass phase is positioned between the Cu-Sn alloy phase and the silicon substrate.

12. A photovoltaic cell, comprising:
the photovoltaic cell element according to any one of claims 9 to 11; and
a tab wire positioned on the electrode of the photovoltaic cell element.
